# EUROPÄISCHE PATENTANMELDUNG

(11) **EP 4 213 191 A2**
(43) Veröffentlichungstag der Anmeldung: **19.07.2023**
(21) Anmeldenummer: 23151074.4
(22) Anmeldetag: 11.01.2023
(51) Int. Cl.: H01L 21/683, H01L 21/67

(54) **VERFAHREN UND VORRICHTUNG ZUM HERSTELLEN EINER HALBLEITERSTRUKTUR**

(30) Priorität: 12.01.2022 DE 102022100661
(71) Anmelder: Forschungsverbund Berlin E.V., 12489 Berlin (DE); IHP GmbH - Innovations for High Performance Microelectronics / Leibniz-Institut für innovative Mikroelektronik, 15236 Frankfurt (Oder) (DE)
(72) Erfinder: Stolze, Karoline, 12489 Berlin (DE); Steglich, Patrick, 15236 Frankfurt (Oder) (DE); Berger, Katrin, 12489 Berlin (DE); Juda, Uta, 12489 Berlin (DE); Martin, Jens, 12489 Berlin (DE)
(74) Vertreter: Eisenführ Speiser

(57) **Zusammenfassung**

Die Erfindung betrifft ein Verfahren zum Herstellen einer Halbleiterstruktur umfassend ein Zielsubstrat und wenigstens ein auf dem Zielsubstrat angeordnetes Halbleiterstück, das vorzugsweise ein III-V-Halbleiterstück ist. Das Verfahren weist die Schritte auf:
- Fixieren eines einkristallinen Halbleiterplättchens, insbesondere eines III-V-Halbleiterplättchens, auf einem Trägersubstrat (604) mittels einer Haftschicht (602),
- Herstellen von wenigstens einem Halbleiterstück (614) aus dem Halbleiterplättchen, wobei das Halbleiterstück mittels der Haftschicht auf dem Trägersubstrat fixiert bleibt,
- Lösen des wenigstens einen Halbleiterstücks von der Haftschicht und dem Trägersubstrat mit einer Transfervorrichtung, und
- Aufbringen des Halbleiterstücks auf das Zielsubstrat mit der Transfervorrichtung.

## Beschreibung

Die Erfindung betrifft ein Verfahren und eine Vorrichtung zum Herstellen einer Halbleiterstruktur, die ein Substrat und wenigstens ein auf dem Substrat angeordnetes Halbleiterstück, insbesondere ein III-V-Halbleiterstück, umfasst.

Nach der *Complementary metal-oxide-semiconductor* (CMOS)-Technik hergestellte Halbleiterbauelemente und mikroelektronische Schaltungen, bei denen sowohl p-Kanal- als auch n-Kanal-Metall-Oxid-Halbleiter-Feldeffekttransistoren (MOSFETs) auf einem gemeinsamen Substrat angeordnet sind, werden in zahlreichen Bereichen der Elektronik eingesetzt. Als gemeinsames Substrat wird in der Regel ein Silizium-Substrat verwendet und die Herstellung der Halbleiterbauelemente und mikroelektronischen Schaltungen auf Silizium auch als Silizium-basierte CMOS-Technik bezeichnet.

Ein Vorteil der CMOS-Technik besteht darin, dass die hergestellten Halbleiterbauelemente und mikroelektronischen Schaltungen in der Regel einen geringen Energieverbrauch haben und im Betrieb wenig Wärme erzeugen. Dadurch ist es möglich eine hohe Dichte an logischen Schaltungen auf einem einzigen Chip zu integrieren und somit ein breites Spektrum an Funktionalitäten bereitzustellen. Die COMS-Technik ermöglicht insbesondere die Herstellung von integrierten Schaltungen umfassend Speicherelemente, Mikroprozessoren aber auch von analogen Schaltungen wie Bildsensoren und Transceivern im industriellen Maßstab.

Um die Funktionalität solcher, nach der Silizium-basierten CMOS-Technik hergestellten Halbleiterbauelemente und mikroelektronischen Schaltungen zu verbessern und/oder zu erweitern sowie um deren Größe und den Energieverbrauch weiter zu verringern, wird versucht andere Halbleitermaterialien in die Silizium-basierte CMOS-Technologie zu integrieren. Von besonderem Interesse ist die Integration von III-V-Verbindungshalbleitern, deren Bandlücke und damit deren optische und elektronische Eigenschaften durch Anpassen der Materialzusammensetzung auf eine bestimmte Anwendung zugeschnitten werden können.

Beispielsweise wurde von J. Zhang et al., in dem Artikel "III-V-on-Si photonic integrated circuits realized using micro-transfer-printing," APL Photonics, Vol. 4, Nr. 11, S. 110803, Nov. 2019 vorgeschlagen, dünne Schichten aus einem III-V-Halbleitermaterial mit Hilfe des von E. Menard, et al. in dem Artikel "A printable form of silicon for high performance thin film transistors on plastic substrates," Appl. Phys. Lett., Vol. 84, Nr. 26, S. 5398-5400, Jun. 2004 beschriebenen *Micro-Transfer-Printing* Verfahrens auf ein Siliziumsubstrat aufzubringen.

In dem von J. Zhang *et al.* vorgeschlagenen Verfahren wird zunächst ein epitaktisches III-V-Halbleiter-Schichtsystem aus einem Ausgangssubstrat, einer Löseschicht und einer Halbleiterbauteilschicht hergestellt. Die Halbleiterbauteilschicht wird dabei epitakitsch auf die Löseschicht aufgebracht. Auf dem Ausgangssubstrat wird die Halbleiterbauteilschicht zu einem optoelektronischen Halbleiterbauteil weiterverarbeitet. Das optoelektronische Halbleiterbauteil wird mit Fotolack bedeckt und anschließend wird die Löseschicht mittels einer Lösung, z.B. einer wässrigen Lösung aus FeCl₃, weggeätzt. Das optoelektronische Halbleiterbauteil ist dann abgelöst und wird mit einem Elastomer-Stempel aufgenommen. Mit dem Elastomer-Stempel wird das optoelektronische Halbleiterbauteil auf ein Zielsubstrat aus Silizium aufgebracht und dort in eine elektronische Schaltung intergiert.

Der Erfindung liegt die Aufgabe zugrunde, ein verbessertes oder zumindest alternatives Verfahren zum Herstellen einer Halbleiterstruktur bereitzustellen. Ferner soll eine Vorrichtung zum Herstellen einer Halbleiterstruktur bereitgestellt werden.

Hinsichtlich des Verfahrens wird die Aufgabe durch ein Verfahren zum Herstellen einer Halbleiterstruktur gelöst, wobei die Halbleiterstruktur ein Zielsubstrat und wenigstens ein auf dem Zielsubstrat angeordnetes Halbleiterstück, das vorzugsweise ein III-V-Halbleiterstück ist, umfasst.

Erfindungsgemäß weist das Verfahren die folgenden Schritte auf:
- Fixieren eines einkristallinen Halbleiterplättchens auf einem Trägersubstrat mittels einer Haftschicht,
- Herstellen von wenigstens einem einkristallinen Halbleiterstück aus dem Halbleiterplättchen, wobei das Halbleiterstück mittels der Haftschicht auf dem Trägersubstrat fixiert bleibt,
- Ablösen des wenigstens einen Halbleiterstücks von der Haftschicht mit einer Transfervorrichtung, und
- Aufbringen des Halbleiterstücks auf das Zielsubstrat mit der Transfervorrichtung.

Unter dem Begriff "einkristallin" wird im Rahmen dieser Beschreibung eine Versetzungsdichte von 10⁵ cm⁻² oder weniger, insbesondere eine Versetzungsdichte von 10⁴ cm⁻² oder weniger, beispielsweise 10² cm⁻² oder weniger, verstanden.

Das Ausgangsprodukt für das Verfahren ist das einkristalline Halbleiterplättchen, das insbesondere ein III-V-Halbleiterplättchen ist. Das einkristalline Halbleiterplättchen kann beispielweise ein Halbleiterwafer oder ein Stück eines Halbleiterwafers sein. Wenn das Halbleiterplättchen aus einem Halbleiterwafer hergestellt wurde, besteht das Halbleiterplättchen aus demselben Material wie der Halbleiterwafer und weist im Wesentlichen dieselbe Versetzungsdichte wie der Halbleiterwafer auf.

Die Erfindung beruht auf den Überlegungen, dass die Integration von Halbleitermaterialien in die Silizium-basierte CMOS-Technologie oftmals mit Schwierigkeiten verbunden ist. Insbesondere lassen sich III-V-Verbindungshalbleiter im Allgemeinen nur durch epitaktisches Wachstum auf einem Substrat, wie einem Silizium-Substrat, herstellen, was aufgrund der typischerweise sehr unterschiedlichen Gitterparameter von Silizium und III-V-Halbleitermaterialien dazu führt, dass die epitaktisch hergestellten III-V-Halbleiterschichten eine hohe Versetzungsdichte aufweisen.

Die Versetzungsdichte bezeichnet dabei die Gesamtlänge aller Versetzungslinien pro Volumeneinheit in einem kristallinen Festkörper und kann als ein Maß für die Qualität von Halbleitersubstraten verwendet werden. Versetzungen sind insbesondere eindimensionale Defekte im Kristallgitter und können beispielsweise Stufen- oder Schraubenversetzungen sein. Insbesondere an der Grenzfläche zwischen einem Siliziumsubstrat und einer epitaktisch aufgebrachten III-V-Halbleiterschicht treten oftmals Defekte wie Fehlversetzungen sowie Flächenfehler, wie Stapelfehler, Zwillingsgrenzen und Antiphasendomänen auf. Auch wenn eine vergleichsweise dicke Pufferschicht verwendet wird, kann eine III-V-Halbleiterschicht nur mit Schwierigkeiten mit einer Versetzungsdichte unterhalb von 10⁷ cm⁻² epitaktisch auf Silizium hergestellt werden. Pufferschichten haben jedoch den weiteren Nachteil, dass die Herstellungsdauer deutlich verlängert wird und zudem die Integration in Silizium-basierte Halbleiterbauteile erschwert wird oder sogar nicht möglich ist.

Defekte wirken sich negativ auf die Kristallqualität und damit in der Regel auch auf die Funktionalität des Halbleitermaterials aus.

Der Erfindung liegt nun die Erkenntnis zugrunde, das Halbleiterwafer und insbesondere III-V-Halbleiterwafer mit einer hohen Kristallqualität, d.h. mit einer geringen Versetzungsdichte, hergestellt werden können. Beispielsweise kann ein Halbleiterwafer aus einem III-V-Einkristall mit einem Durchmesser von 3 Zoll bis 6 Zoll mit einer Versetzungsdichte von 10² cm² oder weniger hergestellt werden. Ein solcher III-V-Einkristall mit einer Versetzungsdichte von 10² cm⁻² oder weniger kann beispielsweise nach dem *Vertical Gradient Freeze*-Verfahren hergestellt werden. Auch das *Vertical* Bridgman-Verfahren oder das Czochralski-Verfahren eignen sich für die Herstellung von III-V-Einkristallen mit einer Versetzungsdichte von 10⁴ cm⁻² oder weniger, beispielsweise von 10³ cm⁻² oder weniger.

Ein Halbleiterwafer wird in der Regel aus einem Einkristall-Ingot hergestellt, z.B. durch Rausschneiden einer Scheibe aus dem Ingot. Der Einkristall-Ingot wird unabhängig von einem Substrat, typischerweise in einem Tiegel, hergestellt. Die Einkristall-Ingots können dabei aus quasi defektfreiem Halbleitermaterial oder aus gezielt verändertem Halbleitermaterial, z.B. dotiertem Halbleitermaterial, bestehen. Dabei kann auf etablierte Verfahren zur Herstellung von Volumeneinkristallen, wie dem Czochralski-Verfahren oder dem *Vertical Gradient Freeze-*Verfahren, zurückgegriffen werden.

Solche, aus einem Volumenkristall hergestellte Halbleiterwaferweisen typischerweise eine deutlich geringere Versetzungsdichte auf, als epitaktisch auf einem Substrat hergestellte III-V-Halbleiterschichten.

Das erfindungsgemäße Verfahren ermöglicht es Halbleitermaterialien, insbesondere III-V-Halbleitermaterialien, mit hoher Kristallqualität, d.h. mit niedriger Versetzungsdichte, in eine Halbleiterstruktur und insbesondere in die Silizium-basierte CMOS-Technologie zu integrieren.

Da das einkristalline Halbleiterplättchen, das das Ausgangsprodukt für das Verfahren darstellt, bereits eine vergleichsweise geringe Versetzungsdichte aufweist, kann daraus ein Halbleiterstück hergestellt werden, das ebenfalls eine geringe Versetzungsdichte aufweist. Beispielweise kann das Halbleiterstück dieselbe Versetzungsdichte wie das Halbleiterplättchen aufweisen. Es ist jedoch auch möglich, dass die Versetzungsdichte des Halbleiterstücks aufgrund der Herstellung des Halbleiterstücks aus dem Halbleiterplättchen im Vergleich zu der Versetzungsdichte des Halbleiterstücks leicht erhöht ist. Beispielsweise kann sich die Versetzungsdichte des Halbleiterstücks durch die Herstellung um eine Größenordnung im Vergleich zu der Versetzungsdichte des Halbleiterplättchens erhöhen. Da aber bereits das Halbleiterplättchen eine vergleichsweise geringe Versetzungsdichte aufweist, liegt die Versetzungsdichte des Halbleiterstücks typischerweise immer noch deutlich unterhalb der Versetzungsdichte einer epitaktisch hergestellten III-V-Halbleiterschicht.

Das erfindungsgemäße Verfahren ermöglicht somit die Integration eines Halbleiterstücks mit einer vergleichsweise niedrigeren Versetzungsdichte, die insbesondere 10⁵ cm⁻² oder weniger, und insbesondere 10⁴ cm⁻² oder weniger, beispielweise 10² cm⁻² oder weniger betragen kann, in eine Halbleiterstruktur. Vorteilhafterweise wird das Halbleiterstück nicht epitaktisch hergestellt. Beispielweise kann mit dem erfindungsgemäßen Verfahren ein einkristallines III-V-Halbleiterstück auf ein Zielsubstrat aus Silizium aufgebracht und somit in Silizium-basierte CMOS-Technik integriert werden.

Das Verfahren hat den weiteren Vorteil, dass nur eine vergleichsweise geringe Menge an Material des Halbleiterplättchens nicht verwendet wird. Bei dem Verfahren geht also im Zuge der Herstellung der Halbleiterstruktur vergleichsweise wenig Material verloren, insbesondere geht wenig Material des Zielsubstrats und/oder wenig Material des Halbleiterplättchens verloren. Das Verfahren ermöglicht somit eine Ressourcen-schonende Herstellung der Halbleiterstruktur.

Damit unterscheidet sich das erfindungsgemäße Verfahren von einer Integration eines Halbleiterstücks in eine Halbleiterstruktur mittels dem Wafer*-bonding* Verfahren, bei dem mit einem vergleichsweise hohen Materialverlust zu rechnen ist. Insbesondere der Verlust an Material des Zielsubstrats fällt bei dem Wafer*-bonding* Verfahren typischerweise vergleichsweise hoch aus. Dies liegt daran, dass insbesondere III-V-Halbleiterwafer mit einem deutlich kleineren Durchmesser hergestellt werden, als dies beispielweise bei einem Silizium-Substrat üblich ist. Zudem wird auch beim Wafer-*bonding* typischerweise die Versetzungsdichte in dem III-V-Halbleiterwafer aufgrund von thermischer Verspannung des Kristalls bei der Verarbeitung erhöht.

Das erfindungsgemäße Verfahren hat somit den weiteren Vorteil, dass aufgrund der vergleichsweise niedrigeren Versetzungsdichte des Halbleiterstücks aus dem auf dem Zielsubstrat aufgebrachten Halbleiterstück ein vergleichsweise leistungsfähiges Halbleiterbauteil hergestellt und in eine auf dem Zielsubstrat vorhandene elektronische Schaltung integriert werden kann.

Das aus dem Halbleiterplättchen hergestellte Halbleiterstück entsteht insbesondere durch mechanische und/oder chemisches Bearbeiten des Halbleiterplättchens. Das Halbleiterstück hat insbesondere ein kleineres Volumen und eine kleinere Grundfläche als das Halbleiterplättchen. Ein Halbleiterstück kann beispielweise eine Grundfläche von 500 µm × 500 µm oder von 200 µm × 300 µm haben.

Aus einem Halbleiterplättchen können auch mehrere Halbleiterstücke hergestellt werden. Die mehreren Halbleiterstücke haben vorzugsweise dieselben Dimensionen. Halbleiterplättchen und Halbleiterstück bestehen aus demselben Material, insbesondere aus einem III-V-Halbleitermaterial.

Zum Herstellen des Halbleiterstücks aus dem Halbleiterplättchen wird das Halbleiterplättchen zunächst auf einem Trägersubstrat fixiert. Durch das Fixieren wird zwischen dem Halbleiterplättchen und dem Trägersubstrat eine Oberflächenhaftung erzeugt, so dass Halbleiterplättchen und Trägersubstrat miteinander verbunden sind. Vorzugsweise sind Halbleiterplättchen und Trägersubstrat mechanisch, physikalisch und/oder chemisch lösbar miteinander verbunden.

Die Haftschicht, die dem Fixieren des Halbleiterplättchens auf dem Trägersubstrat dient, kann einen Haftvermittler umfassen, um so eine enge physikalische und/oder chemische Bindung zwischen Halbleiterplättchen und Trägersubstrat herzustellen.

Das Verfahren eignet sich grundsätzlich für das Herstellen einer Halbleiterstruktur aus einem Halbleiterstück und einem Zielsubstrat aus jeweils unterschiedlichen Materialien, insbesondere aus jeweils unterschiedlichen Halbleitermaterialien. Bevorzugt besteht das Halbleiterplättchen und entsprechend auch das Halbleiterstück aus einem III-V-Halbleitermaterial. Das Zielsubstrat besteht vorzugsweise aus einem in der CMOS-Technik verwendeten Material, wie z.B. Si oder Si₃N₄. Das Verfahren wird also bevorzugt dazu verwendet, ein Halbleiterstück aus einem III-V-Halbleitermaterial in die Silizium-basierte CMOS-Technik zu integrieren.

Das Verfahren kann die weiteren Schritte umfassen:
- Bereitstellen eines einkristallinen Halbleiterwafers, der vorzugsweise ein III-V-Halbleiterwafer ist, und
- Herstellen des Halbleiterplättchens aus dem Halbleiterwafer.

Der Halbleiterwafer hat insbesondere eine Versetzungsdichte von 10⁵ cm⁻² oder weniger, insbesondere einer Versetzungsdichte von 10⁴ cm⁻² oder weniger, beispielweise 10² cm⁻² oder weniger.

Das Herstellen des Halbleiterplättchens aus dem Halbleiterwafer kann umfassen, dass das Halbleiterplättchen mechanisch aus dem Halbleiterwafer herausgeschnitten, herausgesägt oder gebrochen, oder chemisch aus dem Halbleiterwafer herausgelöst wird. Das Halbleiterplättchen ist in diesem Fall ein Stück aus dem Halbleiterwafer, der das Ausgangsprodukt für das Halbleiterplättchen darstellt. Das Halbleiterplättchen hat in diesem Fall insbesondere ein kleineres Volumen und eine kleinere Grundfläche als der Halbleiterwafer.

Das Halbleiterplättchen wird bevorzugt so aus einem Halbleiterwafer hergestellt, dass es eine Grundfläche von 25 mm × 25 mm oder weniger, vorzugsweise 10 mm × 10 mm oder weniger, insbesondere eine Grundfläche zwischen 5 mm × 5 mm und 25 mm × 25 mm, hat. Vorzugsweise hat das Halbleiterplättchen eine Grundfläche von 1 Zoll × 1 Zoll oder weniger.

Die Haftschicht ist bevorzugt aus einem Wachs oder einem Harz gebildet. Die Haftschicht dient insbesondere dazu, eine mechanisch und/oder chemisch lösbare Haftverbindung zwischen dem Halbleiterplättchen und dem Trägersubstrat herzustellen. Das Halbleiterplättchen wird nicht auf der Haftschicht epitaktisch gewachsen, sondern auf dieser durch eine Haftverbindung fixiert. Die Haftschicht dient dazu, das Halbleiterplättchen während des Herstellens des Halbleiterstücks aus dem Halbleiterplättchen zu fixieren, so dass das Halbleiterplättchen auf dem Trägersubstrat weiterverarbeitet, z.B. poliert und/oder dünner gemacht, werden kann. Die Haftschicht dient auch dazu, dass das Halbleiterstück mit der Transfervorrichtung von dem Trägersubstrat abgenommen werden kann, um das Halbleiterstück mit der Transfervorrichtung auf das Zielsubstrat, z.B. ein Silizium-Substrat, zu transferieren. Dafür wird die Haftschicht, wenigstens teilweise aufgelöst, z.B. weggeätzt. Insbesondere wenn das Halbleiterstück vor dem Transferieren eine vergleichsweise geringe Schichtdicke aufweist, kann das Halbleiterstück durch wenigstens teilweises Auflösen oder Wegätzen der Haftschicht mit der Transfervorrichtung von dem Trägersubstrat abgenommen werden, ohne dass das Halbleiterstück dabei beschädigt wird.

Bevorzugt besteht die Haftschicht aus einem Material mit hoher Reinheit und Partikelfreiheit. Es ist weiterhin bevorzugt, dass die Haftschicht aus einem Material besteht, das sich thermisch gut verarbeiten lässt. Das Material der Haftschicht sollte nach einem Aufschmelzen eine geringe bis mittlere Viskosität aufweisen, z.B. von 10² mPa*s oder weniger, bevorzugt von 50 mPa*s oder weniger, insbesondere von 20 mPa*s oder weniger. Bevorzugt ist das Material der Haftschicht unlöslich in Wasser. Das Material der Haftschicht ist bevorzugt in polaren, aprotischen Lösungsmitteln, wie z.B. Aceton oder Chloroform, löslich.

Die Haftschicht kann aus einem Wachs und/oder einem Harz bestehen. Das Wachs kann ein natürliches, d.h. tierisches oder pflanzliches Wachs, ein teilsynthetisches oder ein synthetisches Wachs sein. Beispielsweise kann die Haftschicht aus Bienenwachs bestehen. Die Haftschicht kann aber auch aus einem synthetischen Wachs z.B. aus einem Gemisch aus Hartparaffinen bestehen.

Die Haftschicht kann auch aus einem Naturharz oder einem Kunstharz bestehen, z.B. aus Polyethylenterephthalat (PET).

Die Haftschicht hat bevorzugt eine Schichtdicke von 2 µm oder weniger, bevorzugt zwischen 100 nm und 2 µm, insbesondere zwischen 600 nm und 1,2 µm. Eine Haftschicht mit den angegebenen Schichtdicken, die bevorzugt aus einem Harz oder Wachs besteht, kann gleichmäßig dünn auf das Trägersubstrat aufgebracht werden. Dies hat den Vorteil, dass Kittfehler wie z.B. Kittkeile verhindert werden können. Zudem wird bei den angegebenen Schichtdicken das Risiko für Einschlüsse und/oder Blasen reduziert. Das Halbleitplättchen kann somit planparallel auf dem Trägersubstrat, das insbesondere ein Glassubstrat ist, aufgebracht werden.

Eine Haftschicht mit den angegebenen Schichtdicken von bevorzugt zwischen 2 µm und 100 nm ist geeignet, um das Halbleiterstück effektiv mit einem geeigneten Ätz- und/oder Lösungsmittel freizulegen. Die Haftschicht mit einer Dicke von 100 nm oder mehr ist insbesondere dick genug, so dass ein Ätz- und/oder Lösungsmittel zum Freilegen des Halbleiterstücks unterätzend angreifen kann. Eine Dicke von 2 µm oder weniger ist bevorzugt, da die Zeitdauer bis zum Freilegen des Halbleiterstücks vergleichsweise geringgehalten werden kann. Auch Dicken größer als 2 µm können aber grundsätzlich für die Haftschicht verwendet werden, solange wie das Halbleiterstück auf dem Trägersubstrat im Wesentlichen planparallel aufgebracht werden kann.

Das Trägersubstrat ist vorzugsweise ein Trägerwafer, insbesondere ein Glaswafer. Entsprechend kann das Trägersubstrat aus Glas, insbesondere aus Siliziumdioxid (Quarzglas) oder Borosilikatglas bestehen.

Das Trägersubstrat besteht vorzugsweise aus einem Material, das chemisch inert gegenüber einem in dem Verfahren verwendeten Ätz- und/oder Lösungsmittel ist. Es ist weiterhin bevorzugt, dass das Trägersubstrat aus einem Material besteht, das planar geläppt werden kann.

Das Trägersubstrat hat bevorzugt eine kreisrunde Grundfläche, insbesondere, damit es für die Bearbeitung in handelsüblichen Chemisch-mechanischen-Polier (CMP)-Anlagen eignet.

Bevorzugt umfasst in dem Verfahren das Herstellen des wenigstens einen Halbleiterstücks aus dem Halbleiterplättchen, dass
- eine dem Trägersubstrat abgewandte Oberfläche des Halbleiterplättchens chemisch und/oder mechanisch poliert wird,
- das Halbleiterplättchen von dem Trägersubstrat abgenommen und erneut auf dem Trägersubstrat mittels der Haftschicht fixiert wird, so dass die polierte Oberfläche dem Trägersubstrat zugewandt ist, und
- die zweite nun dem Trägersubstrat abgewandte Oberfläche des Halbleiterplättchens chemisch und/oder mechanisch poliert wird, sodass das Halbleiterplättchen zwei einander gegenüberliegende polierte Oberflächen aufweist.

Das chemisch mechanische Polieren kann beispielweise nach dem Verfahren des chemisch-mechanischen Polierens (engl. *chemical mechanical polishing*) oder nach einem alternativen Polierverfahren durchgeführt werden.

In dem Verfahren kann es somit weiterhin vorgesehen sein, dass mittels chemisch-mechanischen Polierens des Halbleiterplättchens die Oberflächenrauigkeit des Halbleiterplättchens reduziert wird, insbesondere auf weniger als Rₐ=10 nm reduziert wird.

Zum Abnehmen des Halbleiterplättchen von dem Trägersubstrat wird bevorzugt ein Lösungsmittel, z.B. Aceton oder Chloroform, verwendet. Anschließend wird das Halbleiterplättchen vorzugsweise mit Aceton, Chloroform und/oder Isopropanol gereinigt.

Das gereinigte Halbleiterplättchen wird dann vorzugsweise erneut auf dem Trägersubstrat mittels der Haftschicht mit der polierten Oberfläche in Richtung des Trägersubstrats zeigend fixiert. Die Haftverbindung besteht dann zwischen der Haftschicht und der polierten Oberfläche des Halbleiterplättchens.

In dem Verfahren kann das Herstellen des wenigstens einen Halbleiterstücks aus dem Halbleiterplättchen weiterhin umfassen, dass
- eine Schichtdicke des Halbleiterstücks in Richtung des Trägersubstrats bis zu einer Zielschichtdicke von vorzugsweise 10 µm oder weniger, insbesondere zwischen 10 µm und 5 µm, reduziert wird.

Eine Zielschichtdicke von vorzugsweise 10 µm oder weniger, insbesondere zwischen 10 µm und 5 µm, ist besonders bevorzugt, da sich eine solche Zielschichtdicke besonders für eine vor dem Transfer optional durchgeführte lithographische Strukturierung eignet. Ein Halbleiterstück mit einer Zielschichtdicke von vorzugsweise 10 µm oder weniger, insbesondere zwischen 10 µm und 5 µm, kann besonders zuverlässig geätzt und/oder unterätzt werden. Insbesondere dann, wenn die Zielschichtdicke zwischen 10 µm und 5 µm liegt, kann das Halbleiterstück lithographisch bearbeitet werden und nach dem Bearbeiten immer noch einkristallin sein.

In dem Verfahren kann somit weiterhin vorgesehen sein, dass die Schichtdicke auf eine Zielschichtdicke reduziert wird. Ein Reduzieren der Schichtdicke auf eine Zielschichtdicke ist insbesondere dann bevorzugt, wenn das Halbleiterstück aus einem Halbleiterwafer hergestellt wurde, der eine Schichtdicke im Sub-Millimeter-Bereich hat. Ein Halbleiterstück mit einer Schichtdicke im Sub-Millimeter-Bereich kann unter Umständen nicht oder nur schwierig mittels der Transfervorrichtung auf das Zielsubstrat transferiert werden. Ein Reduzieren der Schichtdicke auf die Zieldicke kann somit ein Transferieren des Halbleiterstücks auf das Zielsubstrat ermöglichen.

Das Reduzieren des Hableiterstückes auf die Zielschichtdicke kann in zwei Schritten erfolgen, wobei
- in einem ersten Schritt die Schichtdicke durch mechanisches Schleifen auf eine Dicke zwischen 100 µm und 200 µm reduziert wird, und
- in einem zweiten Schritt die Schichtdicke durch chemisches und/oder mechanisches Polieren auf eine Dicke von 10 µm oder weniger reduziert wird.

Durch das chemische und/oder mechanische Polieren wird vorzugsweise eine Oberflächenrauigkeit erreicht, die weniger als Rₐ=10 nm beträgt.

Der Schritt des Herstellens des wenigstens einen Halbleiterstücks aus dem Halbleiterplättchen kann weiterhin umfassen, dass
- auf einer dem Trägersubstrat abgewandten Seite des Halbleiterstücks wenigstens ein Marker, vorzugsweise aus Si, AI oder Au, aufgebracht wird.

Derwenigstens eine Marker dient insbesondere dazu, die Genauigkeit einer Positionierung des Halbleiterstücks auf dem Zielsubstrat zu verbessern. Bevorzugt finden sich auf dem Zielsubstrat ebenfalls Marker, vorzugsweise aus Si, AI oder Au, so dass der oder die Marker des Halbleiterstücks in Bezug auf den oder die Marker des Zielsubstrats ausgerichtet werden können. Das Halbleiterstück kann dadurch besonders genau an der dafür vorgesehenen Stelle auf dem Zielsubstrat positioniert werden, beispielweise für eine Integration in einen auf dem Zielsubstrat angeordneten elektronischen Schaltkreis. Für die genaue Positionierung des Halbleiterstücks auf dem Zielsubstrat mit Hilfe von Markern können Halbleiterstück und Zielsubstrat optisch mit einer Kamera erfasst werden und die von der Kamera erzeugten Bilddaten mittels Mustererkennung analysiert werden, um so die Markerpositionen zu bestimmen. Auf Basis der ermittelten Markerpositionen kann automatisiert ein Greifarm, z.B. ein Roboterarm, so angesteuert werden, dass dieser das Halbleiterstück greift und in vordefinierter räumlicher Beziehung zu dem Marker des Zielsubstrats auf das Zielsubstrat aufbringt.

Der Schritt des Herstellens des wenigstens einen Halbleiterstücks aus dem Halbleiterplättchen kann weiterhin umfassen, dass
- auf einer dem Trägersubstrat abgewandten Seite des Halbleiterplättchens wenigstens eine lithografische Maske aufgebracht wird, die denjenigen Bereich der dem Trägersubstrat abgewandten Oberfläche des Halbleiterplättchens bedeckt, der eine Oberfläche des herzustellenden Halbleiterstücks bilden soll, und
- das wenigstens eine Halbleiterstück an seinen Seitenflächen durch anisotropes chemisches Ätzen des Halbleiterplättchens in Richtung des Trägersubstrats freigelegt wird und durch die Haftschicht auf dem Trägersubstrat fixiert bleibt.

Mit diesen Schritten wird das Halbleiterstück an seinen Seitenflächen freigelegt. Die Seitenflächen stehen insbesondere senkrecht zu derjenigen Oberfläche, mit der das Halbleiterplättchen auf der Haftschicht aufliegt. Die Größe des Halbleiterstücks kann durch die lithografische Maske vorgegeben werden. Durch die lithografische Maske kann auch die Geometrie der Grundfläche des Halbleiterstücks vorgegeben werden, die z.B. rund oder rechteckig sein kann. Durch die lithografische Maske kann auch die Anzahl an Halbleiterstücken vorgegeben werden, die aus dem Halbleiterplättchen hergestellt werden sollen. Beispielsweise können bis zu 1000 Halbleiterstücke mit einer Fläche von beispielsweise 200 µm × 200 µm aus einem Halbleiterplättchen mit einer Grundfläche von 20 mm × 20 mm hergestellt werden.

Auch die Dichte der Halbleiterstücke, die aus dem Halbleiterplättchen hergestellt werden sollen, kann durch die lithografische Maske vorgegeben werden. Eine Dichte der Halbleiterstücke, die aus einem Halbleiterplättchen hergestellt werden sollen, kann zum Beispiel zwischen 1,5 Stück/mm² und 3,5 Stück/mm² liegen.

Durch das anisotrope chemische Ätzen werden insbesondere die Seitenflächen des Halbleiterstücks freigelegt, ohne dass das Material, das von der lithografischen Maske bedeckt ist, entfernt wird.

Es kann vorteilhaft sein, wenn die Haftschicht in Bereichen, die nicht von der lithografischen Maske bedeckt sind, entfernt wird, so dass die dem Halbleiterplättchen zugewandte Seite des Trägersubstrats an diesen Stellen freigelegt wird. Das Entfernen der Haftschicht erfolgt insbesondere in einem sich an das anisotrope chemische Ätzen des Halbleiterplättchens anschließenden Schritt. Zum Entfernen der Haftschicht wird vorzugsweise ein aprotisches Lösungsmittel verwendet. Die Haftschicht befindet sich dann vorzugsweise nur noch auf denjenigen Bereichen des Trägersubstrats, an denen ein Halbleiterstück angeordnet ist. In den übrigen Bereichen liegt die dem Halbleiterplättchen bzw. dem Halbleiterstück oder den Halbleiterstücken zugewandte Seite des Trägersubstrats nach dem anisotropen chemischen Ätzen frei.

Alternativ kann es auch vorteilhaft sein, wenn die Haftschicht in Bereichen, die nicht von der lithografischen Maske bedeckt sind, nicht entfernt wird. Die Haftschicht bleibt dann vollständig intakt. In diesem Fall wird die Haftschicht an denjenigen Stellen, die nicht von einem Halbleiterstück oder Halbleiterstücken bedeckt sind, freigelegt.

Nach dem anisotropen chemischen Ätzen des Halbleiterplättchens in Richtung des Trägersubstrats sind je nach lithografischer Maske eines oder mehrere Halbleiterstücke an ihren Seitenflächen freigelegt. Das eine oder die mehreren Halbleiterstücke sind dann weiterhin mittels der Haftschicht auf dem Trägersubstrat fixiert, liegen an ihren übrigen Außenflächen aber frei.

Vorzugsweise wird vor dem Lösen des wenigstens einen Halbleiterstücks von der Haftschicht und dem Trägersubstrat mit der Transfervorrichtung eine Schutzschicht auf das Halbleiterstück aufgebracht, so dass die Schutzschicht das Halbleiterstück wenigstens teilweise umschließt. Bevorzugt wird die Schutzschicht so auf das Halbleiterstück aufgebracht, dass die Schutzschicht in wenigstens einem Bereich eine Öffnung aufweist, durch die die zwischen dem Halbleiterstück und dem Trägersubstrat angeordnete Haftschicht von außen zugänglich ist. Die Öffnung dient insbesondere dazu, dass ein Ätz- und/oder Lösungsmittel in Kontakt mit der Haftschicht gebracht werden kann, um diese zu entfernen. Ein Entfernen der Haftschicht meint hierbei, dass Rückstände der Haftschicht in geringfügigen Mengen weiterhin vorhanden sein können. Bevorzugt ist allerdings ein im Wesentlichen vollständiges Entfernen der Haftschicht.

Zum Aufbringen der Schutzschicht wird zunächst eine weitere lithographische Maske auf das Halbleiterstück oder auf die Halbleiterstücke aufgebracht. Die lithographische Maske ist insbesondere so gestaltet, dass die Schutzschicht mit wenigstens einer Öffnung aufgebracht wird, durch die die Haftschicht zwischen dem Halbleiterstück und Trägersubstrat von außen zugänglich bleibt. Die lithographische Maske besteht vorzugsweise aus einem Material, das nicht durch ein aprotisches Lösungsmittel, wie z.B. Aceton oder Chloroform, entfernt werden kann. Die lithographische Maske wird vorzugsweise mit einem anderen Stoff oder Mittel entfernt, als die Haftschicht. Vorzugsweise verbleibt die lithographische Maske bis nach dem Transfer auf dem Halbleiterstück und kann danach durch Abschälen (engl. *peel*) oder z.B. durch ein Lösungsmittel wie Dimethylsulfoxid (DMSO) oder einen Resist-Entferner entfernt werden. Vorzugsweise wird die Schutzschicht durch die lithographische Maske selbst gebildet.

Die lithographische Maske ist weiterhin insbesondere so gestaltet, dass die Schutzschicht wenigstens eine Haltestruktur als Verankerung umfasst, die - falls die Haftschicht zwischen den Halbleiterstücken entfernt wurde - in Kontakt mit dem Trägersubstrat ist, oder - falls die Haftschicht zwischen den Halbleiterstücken nicht entfernt wurde - in Kontakt mit der Haftschicht ist. Die Schutzschicht bedeckt insbesondere die dem Trägersubstrat abgewandte Oberfläche des Halbleiterstücks und wenigstens eine Seitenfläche des Halbleiterstücks. Der an der wenigstens eine Seitenfläche des Halbleiterstücks befindliche Teil der Schutzschicht kann sich weiter bis auf die angrenzende Oberfläche des Trägersubstrats erstrecken, um so die Haltestruktur der Schutzschicht zu bilden. Die Haltestruktur der Schutzschicht dient insbesondere dazu, das Halbleiterstück zu halten, wenn die Haftschicht zwischen dem Halbleiterstück und dem Trägersubstrat wenigstens teilweise entfernt wurde. Die Haltestruktur der Schutzschicht dient weiterhin als Verankerung, an der das Halbleiterstück von dem Trägersubstrat mittels der Transfervorrichtung gelöst werden kann.

Die Schutzschicht ist vorzugsweise aus einem Polymer und insbesondere aus einem thermisch stabilen Negativlack gebildet. Die Schutzschicht verbleibt auf dem Halbleiterstück. Wenn das Halbleiterstück mit der Transfervorrichtung gelöst wird, wird die Transfervorrichtung insbesondere mit der auf dem Halbleiterstück befindlichen Schutzschicht in Kontakt gebracht. Mit der Transfervorrichtung werden dann das Halbleiterstück mit der Schutzschicht aufgenommen und auf das Zielsubstrat transferiert. Die polierte Oberfläche wird dann während des Transferierens durch die Schutzschicht geschützt. Nachdem das Halbleiterstück auf das Zielsubstrat aufgebracht wurde, kann die Schutzschicht entfernt werden, z.B. durch Abschälen (engl. *peel*) oder mittels eines Lösungsmittels wie DMSO oder mittels eines Resist-Entferners, um das Halbleiterstück zu einem Halbleiterbauteil weiterzuverarbeiten und dieses in eine elektronische Schaltung zu integrieren.

Die Schutzschicht ist insbesondere so ausgebildet und angeordnet, dass ein selektives Entfernen der zwischen dem Halbleiterstück und dem Trägersubstrat angeordneten Haftschicht ermöglicht wird.

In dem Verfahren wird bevorzugt vor dem Lösen des wenigstens einen Halbleiterstücks von der Haftschicht und dem Trägersubstrat mit der Transfervorrichtung die Haftschicht zwischen dem Halbleiterstück und dem Trägersubstrat entfernt. Die Haftschicht wird vorzugsweise vollständig, also ohne Rückstände, zwischen dem Halbleiterstück und dem Trägersubstrat entfernt. Das Halbleiterstück liegt dann frei auf dem Trägersubstrat auf und/oder kann durch die Haltestruktur der Schutzschicht auf dem Trägersubstrat gehalten werden.

Die Transfervorrichtung weist vorzugsweise eine Aufnahmeschicht auf und das Halbleiterstück wird zum Lösen von der Haftschicht und dem Trägersubstrat in Kontakt mit der Aufnahmeschicht gebracht und haftet dann an der Aufnahmeschicht. Die Aufnahmeschicht kann so gestaltet sein, dass diese eine Noppenstruktur aufweist. Die Noppen sind vorzugsweise so ausgebildet, dass mit einer Noppe genau ein Halbleiterstück von dem Trägersubstrat gelöst werden kann. Eine Oberfläche einer Noppe hat vorzugsweise im Wesentlichen dieselbe Geometrie und Größe wie die dem Trägersubstrat abgewandte Oberfläche eines Halbleiterstücks. Die Noppen der Noppenstruktur können gerade so angeordnet sein, dass mit der Noppenstruktur mehrere Halbleiterstücke gleichzeitig von dem Trägersubstrat gelöst werden können. Die Noppen der Noppenstruktur sind vorzugsweise in demselben Muster angeordnet, in dem auch die von dem Trägersubstrat abzulösenden Halbleiterstücke auf dem Trägersubstrat angeordnet sind.

Die Transfervorrichtung ist vorzugsweise so ausgebildet, dass es möglich ist, die Halbleiterstücke durch die Aufnahmeschicht und insbesondere deren Noppenstruktur hindurch optisch mit einem Mikroskop abzubilden. Es ist dann möglich die Halbleiterstücke mit einem Mikroskop durch die Aufnahmeschicht hindurch vergrößert anzusehen und die Noppen der Noppenstruktur in Bezug auf die Halbleiterstücke auszurichten.

Ein Ausrichten der Noppenstruktur in Bezug auf die Halbleiterstücke kann sowohl händisch, also manuell, oder aber auch automatisiert, durch eine Maschine, durchgeführt werden. Zum Erhöhen der Genauigkeit der Ausrichtung können Marker verwendet werden. Marker können beispielweise auf den Halbleiterstücken und/oder auf dem Zielsubstrat angebracht sein. Solche Marker können auch softwarebasiert mittels Mustererkennung erkannt und zur Steuerung einer zum Ausrichten verwendete Maschine, z.B. einer Ausrichtevorrichtung, genutzt werden. Wenn auf dem Halbleiterstück eine Schutzschicht angeordnet ist, wird insbesondere die Schutzschicht in Kontakt mit der Aufnahmeschicht gebracht.

Die Aufnahmeschicht kann beispielsweise aus Polydimethylsiloxan (PDMS) oder einem anderen Siloxan bestehen. Die Aufnahmeschicht wird vorzugsweise von einem Glassubstrat gehalten, so dass die Transfervorrichtung insbesondere ein Glassubstrat und eine darauf angeordnete Aufnahmeschicht, bevorzugt aus PDMS, umfasst. Vorzugsweise ist die Transfervorrichtung optisch transparent.

Um das Halbleiterstück mit der Transfervorrichtung aufzunehmen, also von der Haftschicht zu lösen, wird die Aufnahmeschicht der Transfervorrichtung mit dem Halbleiterstück in Kontakt gebracht und dann mit vergleichsweise hoher Geschwindigkeit von dem Trägersubstrat wegbewegt. Die Geschwindigkeit, mit der die Transfervorrichtung zum Lösen des Halbleiterstücks von dem Trägersubstrat wegbewegt wird, wird insbesondere so gewählt, dass die aufgrund der Geschwindigkeit zwischen der Aufnahmeschicht und dem Halbleiterstück wirkende Adhäsionskraft ausreicht, um das Halbleiterstück von der Haftschicht zu lösen. Bevorzugt hat die Bewegungsrichtung, entlang derer die Transfervorrichtung zum Lösen des Halbleiterstücks von dem Trägersubstrat wegbewegt wird, sowohl eine Richtungskomponente senkrecht zu derjenigen Oberfläche des Trägersubstrats, auf der das Halbleiterstück angeordnet ist, als auch eine Richtungskomponente parallel zu dieser Oberfläche. Die Transfervorrichtung wird also bevorzugt nicht nur schnell abgehoben, sondern zusätzlich seitlich verschoben.

Zum Aufbringen des Halbleiterstücks auf das Zielsubstrat wird das Halbleiterstück mit der Transfervorrichtung mit dem Zielsubstrat in Kontakt gebracht. Wenn sich das Halbleiterstück in Kontakt mit dem Zielsubstrat befindet, wird die Transfervorrichtung vergleichsweise langsam von dem Zielsubstrat wegbewegt, so dass sich das Halbleiterstück von der Aufnahmeschicht der Transfervorrichtung löst und auf dem Zielsubstrat verbleibt. Die Adhäsionskraft zwischen Halbleiterstück und Transfervorrichtung ist aufgrund der entsprechend gewählten geringen Geschwindigkeit so gering, dass sich das Halbleiterstück von der Transfervorrichtung löst und auf dem Zielsubstrat verbleibt.

Diese Vorgehensweise ist besondere dann möglich, wenn die Rauigkeit der Oberflächen des Zielsubstrats vergleichsweise gering ist, und insbesondere weniger als 5 nm beträgt. Die Haftung des Halbleiterstücks an der Oberfläche des Zielsubstrats kann dann durch Van der Waals-Kräfte realisiert werden. Die wirkenden Van der Waals-Kräfte sind dann entsprechend größer als die zwischen dem Halbleiterstück und der Transfervorrichtung wirkende Adhäsionskraft. Die Geschwindigkeit, mit der die Transfervorrichtung von dem Halbleiterstück wegbewegt wird, wird entsprechend so gewählt, dass zwischen dem Zielsubstrat und dem Halbleiterstück wirkende Van der Waals-Kräfte größer sind als die zwischen dem Halbleiterstück und der Transfervorrichtung wirkende Adhäsionskraft.

Sollten Van der Waals-Kräfte nicht ausreichen, um das Halbleiterstück auf dem Zielsubstrat aufzubringen, kann ein Haftvermittler, wie z.B. Benzocyclobuten (BCB) oder ein Resist wie Fotolack, verwendet werden.

Die Transfervorrichtung kann ausgebildet sein, mehrere Halbleiterstücke gleichzeitig aufzunehmen und auf dasselbe oder auf unterschiedliche Zielsubstrate aufzubringen. Das Verfahren kann so in paralleler Weise und dadurch besonders effizient ausgeführt werden.

Das Halbleiterplättchen und entsprechend auch das daraus hergestellte Halbleiterstück besteht vorzugsweise aus einem Halbleitermaterial mit direkter Bandlücke, insbesondere aus GaAs, InP, InAs, InSb, GaSb, oder GaN oder aus einem Halbleitermaterial mit indirekter Bandlücke, vorzugsweise aus GaP oder SiC. Wenn das Halbleiterplättchen aus einem Halbleiterwafer hergestellt wurde besteht entsprechend auch der Halbleiterwafer aus einem Halbleitermaterial mit direkter Bandlücke, insbesondere aus GaAs, InP, InAs, InSb, GaSb, oder GaN oder aus einem Halbleitermaterial mit indirekter Bandlücke, vorzugsweise aus GaP oder SiC.

Durch Integration der vorstehend genannten III-V-Halbleitermaterialien kann die Funktionalität von nach der Silizium-basierten CMOS-Technik hergestellten Halbleiterbauteilen insbesondere auf den THz-Spektralbereich erweitert werden.

Insbesondere GaAs und InP weisen im Vergleich zu Si besonders gute elektronische und optische Eigenschaften auf. InP weist beispielweise eine hohe Elektronenbeweglichkeit auf und ermöglicht den Zugang zu Frequenzen von mehr als 100 GHz bei einer Latenz im Nanosekundenbereich. Zudem emittiert InP Licht im Wellenlängenbereich von 0,9 µm bis 2 µm, der für glasfaserbasierte Telekommunikations- und Datenübertragungssysteme mit geringer Signaldämpfung verwendet wird sowie für hochsensitiven Sensoranwendungen. InP-basierte 1550-nm-Laser, z. B. für LiDAR (engl. *Light detection and ranging*)-Anwendungen, ermöglichen Laserleistungen, die etwa 100 Mal größer sind, als diejenige von anderen Infrarot-Lasern.

Das Zielsubstrat kann aus Si, SiN, Ge, AIO, oder aus einem Schichtsystem aus Si und Benzocyclobuten (BCB), wobei BCB diejenige Substratoberfläche bildet, auf die ein Halbleitstück aufgebracht werden kann, oder SO₂ bestehen. Mit dem erfindungsgemäßen Verfahren wird somit insbesondere die Integration eines einkristallinen Halbleiterstücks, insbesondere eines III-V-Halbleiterstücks, in die Silizium-basierte CMOS-Technik möglich.

Die Erfindung betrifft auch ein Halbleiter-Zwischenprodukt umfassend ein einkristallines Halbleiterstück, das insbesondere ein III-V-Halbleiterstück ist, mit einer Versetzungsdichte von 10⁵ cm⁻² oder weniger, insbesondere 10⁴ cm⁻² oder weniger, beispielweise 10² cm⁻² oder weniger, das mittels einer Haftschicht aus Wachs oder Harz auf einem Trägersubstrat fixiert ist.

Das Halbleiter-Zwischenprodukt kann insbesondere im Rahmen des vorstehend beschriebenen Verfahrens hergestellt werden. Das Halbleiter-Zwischenprodukt kann dazu verwendet werden, das einkristalline Halbleiterstück mit einer Transfervorrichtung wie vorstehend beschrieben auf ein Zielsubstrat zu transferieren, um so eine Halbleiterstruktur umfassend ein Zielsubstrat und das darauf angeordnete Halbleiterstück herzustellen.

Die Erfindung betrifft auch einen Halbleiter-Die, der eine Halbleiterstruktur mit einem Substrat und einem Halbleiterstück, das insbesondere ein III-V-Halbleiterstück ist, umfasst, wobei das Halbleiterstück eine Versetzungsdichte von weniger als 10⁵ cm⁻², insbesondere 10⁴ cm⁻² oder weniger, beispielweise 10² cm⁻² oder weniger, aufweist.

Die Halbleiterstruktur des Halbleiter-Die kann insbesondere nach dem vorstehend beschriebenen Verfahren hergestellt worden sein.

Hinsichtlich der Vorrichtung wird die eingangs genannte Aufgabe durch eine Vorrichtung zum Herstellen einer Halbleiterstruktur umfassend ein Zielsubstrat und wenigstens ein auf dem Zielsubstrat angeordnetes Halbleiterstück, das insbesondere ein III-V-Halbleiterstück ist, gelöst. Die Vorrichtung ist dazu ausgebildet:
- ein einkristallines Halbleiterplättchen, insbesondere ein III-V-Halbleiterplättchen, auf einem Trägersubstrat, insbesondere einem Trägerwafer, mittels einer Haftschicht zu fixieren,
- wenigstens ein Halbleiterstück aus dem Halbleiterplättchen herzustellen, wobei das Halbleiterstück während des Herstellens mittels der Haftschicht auf dem Trägersubstrat fixiert bleibt,
- das wenigstens eine Halbleiterstück von der Haftschicht und dem Trägersubstrat mit einer Transfervorrichtung zu lösen, und
- das Halbleiterstück mit der Transfervorrichtung auf das Zielsubstrat aufzubringen.

Die Vorrichtung kann weiterhin dazu ausgebildet sein,
- das Halbleiterplättchen, insbesondere das III-V-Halbleiterplättchen, aus einem einkristallinen Halbleiterwafer mit einer Versetzungsdichte von 10⁵ cm⁻² oder weniger, und insbesondere 10⁴ cm⁻² oder weniger, beispielweise 10² cm⁻² oder weniger, herzustellen.

Der Halbleiterwafer ist vorzugsweise ein III-V-Halbleiterwafer. Das Zielsubstrat ist vorzugsweise ein Silizium-Substrat oder ein Substrat, das Silizium enthält. Die Vorrichtung ermöglicht es insbesondere ein Halbleiterstück, das insbesondere ein III-V Halbleiterstück ist, in die Silizium-basierte CMOS-Technik zu integrieren.

Mit der erfindungsgemäßen Vorrichtung kann insbesondere das vorstehend beschriebene Verfahren zum Herstellen einer Halbleiterstruktur durchgeführt werden.

Die Vorrichtung kann insbesondere eine oder mehrere der nachfolgend aufgelisteten Komponenten umfassen:
- ein Trägersubstrat mit Haftschicht, wobei das Trägersubstrat insbesondere aus Glas besteht und die Haftschicht aus Wachs und/oder Harz gebildet ist,
- eine automatische Greifvorrichtung zum Fixieren des Halbleiterplättchens auf dem Trägersubstrat, z.B. ein Roboterarm mit einem Greifer, der ausgebildet und angeordnet ist, das Halbleiterplättchen zu greifen und dieses zum Fixieren auf die Haftschicht aufzubringen und dann wieder loszulassen,
- eine Poliervorrichtung, die insbesondere ausgebildet ist, das Halbleiterplättchen durch chemisch und mechanisches Polieren zu bearbeiten und die Oberflächenrauigkeit dadurch auf weniger als Rₐ=10 nm zu reduzieren,
- eine Schleifvorrichtung, z.B. mit einer Diamantschleifscheibe, zum Dünnen des Halbleiterplättchens, insbesondere bis auf eine vorgegebene Zielschichtdicke,
- eine Lithographie-Vorrichtung zum Aufbringen einer lithografischen Maske und zum Ätzen des Halbleiterplättchens, so dass eines oder mehrere Halbleiterstücke hergestellt werden können,
- ein Zielsubstrat, auf das das Halbleiterstück aufgebracht werden soll, um so eine Halbleiterstruktur herzustellen, und/oder
- eine Transfervorrichtung, die von der Greifvorrichtung geführt werden kann, um das Halbleiterstück auf das Zielsubstrat aufzubringen.

Die Vorrichtung kann optional weiterhin umfassen:
- einen einkristallinen Halbleiterwafer, insbesondere einen einkristallinen III-V-Halbleiterwafer, und/oder
- eine Säge zum Ausschneiden des einkristallinen Halbleiterplättchens aus dem Halbleiterwafer, wobei die Säge eine automatische Säge oder eine manuelle Säge sein kann, und/oder
- eine Ausrichtevorrichtung, zum Ausrichten der Transfervorrichtung in Bezug auf die auf dem Trägersubstrat angeordneten Halbleiterstücke.

Die automatische Greifvorrichtung kann weiterhin ausgebildet sein, das auf der Haftschicht fixierte Halbleiterplättchen abzunehmen und umgedreht wieder auf der Haftschicht zu fixieren, so dass sich diejenige Oberfläche des Halbleiterplättchens, die zuvor in Richtung des Trägersubstrats gezeigt hat, auf der dem Trägersubstrat abgewandten Seite des Halbleiterplättchens befindet.

Die Lithographie-Vorrichtung kann weiterhin dazu ausgebildet sein, eine lithografische Maske auf ein Halbleiterstück aufzubringen, so dass eine Schutzschicht mit wenigstens einer Öffnung auf das Halbleiterstück aufgebracht werden kann. Die Öffnung der Schutzschicht ist insbesondere so angeordnet, dass eine zwischen dem Halbleiterstück und dem Trägersubstrat angeordnete Haftschicht von außen zugänglich ist und mittels eines Ätz- oder Lösungsmittels wenigstens teilweise entfernt werden kann.

Die Erfindung soll nun anhand von Ausführungsbeispielen mit Bezug auf die Figuren näher erläutert werden. Von den Figuren zeigt:
- Fig. 1:: schematisch ein Ablaufdiagramm für ein Verfahren zum Herstellen einer Halbleiterstruktur;
- Fig. 2:: eine schematisch dargestellte Vorrichtung zum Herstellen einer Halbleiterstruktur;
- Fig. 3:: eine fotographische Abbildung eines Halbleiterplättchens aus InP mit einer Dicke von 700 µm auf einem Trägersubstrat aus Glas, wobei die dem Trägersubstrat abgewandte Oberfläche des Halbleiterplättchens chemisch-mechanisch poliert wurde;
- Fig. 4:: eine fotographische Abbildung des in Fig. 3 gezeigten Halbleiterplättchens, nachdem dieses umgedreht, die Schichtdicke bis auf weniger als 10 µm reduziert und die nach dem Umdrehen dem Trägersubstrat abgewandte Oberfläche des Halbleiterplättchens chemisch-mechanisch poliert wurde;
- Fig. 5:: eine mikroskopische Abbildung der chemisch-mechanisch polierten des in Fig. 4 gezeigten Halbleiterplättchens;
- Fig. 6:: schematisch und beispielhaft ein III-V-Halbleiterplättchen in einer Seitenansicht, das mittels einer Haftschicht aus Wachs oder Harz auf einem Trägersubstrat aus Glas fixiert ist;
- Fig. 7:: schematisch und beispielhaft ein III-V-Halbleiterplättchen in einer Seitenansicht, das mittels einer Haftschicht aus Wachs oder Harz auf einem Trägersubstrat aus Glas fixiert ist, wobei auf dem III-V-Halbleiterplättchen eine lithographische Maske aufgebracht ist, die die Größe der Halbleiterstücke vorgibt;
- Fig. 8:: schematisch und beispielhaft drei III-V-Halbleiterstücke in einer Seitenansicht, die durch anisotropes chemisches Ätzen eines III-V-Halbleiterplättchens hergestellt wurden und mittels einer Haftschicht an dem Trägersubstrat aus Glas fixiert sind, wobei die Haftschicht in den Bereichen zwischen den III-V-Halbleiterstücken mit einem Lösungsmittel entfernt wurde;
- Fig. 9:: schematisch und beispielhaft die drei in Fig. 8 gezeigten III-V-Halbleiterstücke in einer Seitenansicht, wobei die lithographische Maske entfernt wurde;
- Fig. 10:: schematisch und beispielhaft das in Fig. 9 gezeigte Halbleiter-Zwischenprodukt umfassend ein Trägersubstrat auf dem mittels einer Haftschicht mehrere Halbleiterstücke fixiert sind in einer Draufsicht;
- Fig. 11:: schematisch und beispielhaft ein Halbleiter-Zwischenprodukt umfassend ein Trägersubstrat auf dem mittels einer Haftschicht drei III-V-Halbleiterstücke fixiert sind in einer Seitenansicht;
- Fig. 12:: schematisch und beispielhaft das in Fig. 11 gezeigte Halbleiter-Zwischenprodukt, wobei auf die III-V-Halbleiterstücken jeweils eine Schutzschicht aufgebracht ist;
- Fig. 13:: schematisch und beispielhaft das in Fig. 12 gezeigte Halbleiter-Zwischenprodukt, wobei die Haftschicht zwischen den III-V-Halbleiterstücken und dem Trägersubstrat entfernt wurde;
- Fig. 14: schematisch und beispielhaft eine Halbleiterstruktur umfassend ein Zielsubstrat und drei auf dem Zielsubstrat angeordneten Halbleiterstücken;
- Fig. 15:: schematisch und beispielhaft drei III-V-Halbleiterstücke in einer Seitenansicht, die durch anisotropes chemisches Ätzen des in Fig. 7 gezeigten III-V-Halbleiterplättchens hergestellt wurden und mittels einer Haftschicht an dem Trägersubstrat aus Glas fixiert sind, wobei die Haftschicht vollständig intakt ist;
- Fig. 16:: schematisch und beispielhaft die drei in Fig. 15 gezeigten III-V-Halbleiterstücke in einer Seitenansicht, wobei die lithographische Maske entfernt wurde;
- Fig. 17:: schematisch und beispielhaft das in Fig. 16 gezeigte Halbleiter-Zwischenprodukt umfassend ein Trägersubstrat auf dem mittels einer Haftschicht mehrere Halbleiterstücke fixiert sind in einer Draufsicht;
- Fig. 18:: schematisch und beispielhaft ein Halbleiter-Zwischenprodukt umfassend ein Trägersubstrat auf dem mittels einer Haftschicht drei III-V-Halbleiterstücke fixiert sind in einer Seitenansicht;
- Fig. 19:: schematisch und beispielhaft das in Fig. 18 gezeigte Halbleiter-Zwischenprodukt, wobei auf die III-V-Halbleiterstücken jeweils eine Schutzschicht aufgebracht ist;
- Fig. 20:: schematisch und beispielhaft drei III-V-Halbleiterstücke auf einem Trägersubstrat, wobei die Haftschicht unter dem mittleren III-V-Halbleiterstück vollständig entfernt wurde;
- Fig. 21:: schematisch und beispielhaft eine Halbleiterstruktur umfassend ein Zielsubstrat und ein auf dem Zielsubstrat angeordnetes Halbleiterstück.

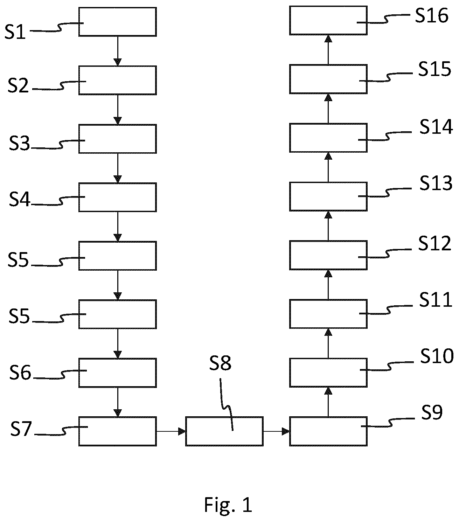

Figur 1 zeigt schematisch ein Ablaufdiagramm für ein Verfahren zum Herstellen einer Halbleiterstruktur. Die mit dem Verfahren hergestellte Halbleiterstruktur umfasst ein Zielsubstrat und ein auf dem Zielsubstrat angeordnetes Halbleiterstück.

In dem Verfahren wird zunächst ein Halbleiterwafer aus InP bereitgestellt (Schritt S1), der eine Versetzungsdichte von 10³ cm⁻² aufweist. Der Halbleiterwafer ist also ein einkristalliner Halbleiterwafer. Alternativ könnte der Halbleiterwafer aber auch aus einem anderen III-V Halbleitermaterial wie z.B. GaAs InAs, InSb, GaSb, GaP, oder GaN bestehen. Der Halbleiterwafer kann alternativ aber auch aus einem Verbindungshalbleitermaterial mit indirekter Bandlücke der Gruppe IV bestehen, wie z.B. SiC. Der Halbleiterwafer kann beispielsweise ein 2-Zoll, 4-Zoll oder 6-Zoll Wafer sein.

Zum Herstellen der Halbleiterstruktur wird zunächst ein einkristallines Halbleiterplättchen aus dem Halbleiterwafer herausgesägt (Schritt S2), z.B. mit einer Säge mit einem Diamantsägeblatt. Alternativ könnte das Halbleiterplättchen auch durch Brechen des Halbleiterwafers hergestellt werden. Es ist auch möglich, dass auf dem Halbleiterwafer eine lithografische Maske aufgebracht und das Halbleiterplättchen durch chemisches ätzen in den nicht von der lithografischen Maske bedeckten Bereichen hergestellt wird.

Das Halbleiterplättchen besteht aus InP und weist ebenfalls eine Versetzungsdichte von 10³ cm⁻² auf. Das Halbleiterplättchen hat eine rechteckige Grundfläche, wobei die Seitenlängen des Halbleiterplättchens 12 mm betragen. Die Seitenlängen des Halbleiterplättchens könnten aber auch zwischen 5 mm und 25 mm betragen. Das Halbleiterplättchen hat eine Dicke die der ursprünglichen Dicke des Halbleiterwafers entspricht und hier 800 µm beträgt.

Das Halbleiterplättchen wird auf einem Trägersubstrat aus Siliziumdioxid mittels einer Haftschicht fixiert (Schritt S3). Das Trägersubstrat könnte aber auch aus einem anderen Glas wie Borosilikatglas bestehen.

Die Haftschicht besteht aus einem Kunstharz, nämlich Polyethylenterephthalat (PET). Die Haftschicht könnte aber auch aus einem anderen Kunstharz bestehen. Die Haftschicht könnte auch aus einem Naturharz gebildet sein. Alternativ zu einer Haftschicht aus einem Harz könnte auch eine Haftschicht aus einem Wachs verwendet werden. Das Wachs kann ein natürliches, teilsynthetisches oder synthetisches Wachs sein. Als natürliches Wachs kann z.B. Bienenwachs verwendet werden. Als synthetisches Wachs könnte z.B. ein Gemisch aus Hartparaffinen verwendet werden.

Die Haftschicht hat eine Dicke von 1 µm und ermöglicht es das Halbleiterplättchen plan und ohne Einschlüsse oder Blasen in der Haftschicht auf der Haftschicht zu fixieren. Die Haftschicht könnte alternativ aber auch eine Dicke haben, die zwischen 100 nm und 2 µm beträgt.

Aus dem auf der Haftschicht fixierten Halbleiterplättchen wird anschließend ein Halbleiterstück hergestellt (Schritt S4). Aus dem Halbleiterplättchen könnten aber auch gleichzeitig mehrere Halbleiterstücke parallel hergestellt werden.

Zum Herstellen des Halbleiterstücks wird zunächst die dem Trägersubstrat abgewandte Oberfläche des Halbleiterplättchens chemisch und mechanisch poliert (Schritt S5). Nach dem Polieren beträgt die Oberflächenrauigkeit der polierten Oberfläche des Halbleiterplättchens eine Rauigkeit von 10 nm.

Das Halbleiterplättchen mit der polierten Oberfläche wird anschließend mittels Aceton oder Chloroform von der Haftschicht gelöst und von dieser abgenommen (Schritt S6). Das abgenommene Halbleiterplättchen wird mit Aceton oder alternativ mit Chloroform oder Isopropanol gereinigt (Schritt S7).

Anschließend wird das Halbleiterplättchen mit der polierten Oberfläche, die der unpolierten Oberfläche gegenüberliegt, erneut auf dem Trägersubstrat mittels der Haftschicht fixiert (Schritt S8), sodass nun die unpolierte Oberfläche des Halbleiterplättchens die dem Trägersubstrat abgewandte Seite des Halbleiterplättchens bildet.

Das erneut auf der Haftschicht fixierte Halbleiterplättchen wird nun so weiterbearbeitet, dass zunächst dessen Schichtdicke durch mechanisches Schleifen mit einer Diamantschleifscheibe bis auf eine Schichtdicke von ungefähr 100 µm reduziert wird (Schritt S9). Die Schichtdicke wird anschließend durch chemisches und mechanisches Polieren auf eine Zielschichtdicke von 8 µm weiter reduziert (Schritt S10). Die Zielschichtdicke könnte aber auch zwischen 5 µm und 10 µm betragen.

Auf der dem Trägersubstrat abgewandten Oberfläche des Halbleiterplättchens wird eine lithografische Maske aufgebracht, die denjenigen Bereich der Oberfläche des Halbleiterplättchens bedeckt, der eine Oberfläche des Halbleiterstücks bilden soll (Schritt S11). Anschließend werden diejenigen Bereiche, die nicht von der lithografischen Maske bedeckt sind, durch anisotropes chemisches Ätzen des Halbleiterplättchens in Richtung des Trägersubstrats entfernt (Schritt S12) und dadurch die Seitenflächen des Halbleiterstücks freigelegt.

Nach dem anisotropen chemischen Ätzen existiert somit nur noch das freigelegte Halbleiterstück, das weiterhin mittels der Haftschicht auf dem Trägersubstrat fixiert ist. Durch das anisotrope chemische Ätzen wurden diejenigen Bereiche der Haftschicht, auf denen sich kein Halbleiterstück befindet, freigelegt. Die dem Halbleiterstück zugewandte Oberfläche der Haftschicht ist somit an denjenigen Stellen freigelegt, die nicht von dem Halbleiterstück bedeckt sind. Die Haftschicht wird dann an den durch das Ätzen freigelegten Stellen mittels eines Lösungsmittels entfernt, so dass sich die Haftschicht nur noch in dem Bereich zwischen dem Trägersubstrat und dem Halbleiterstück befindet. Dadurch wird die dem Halbleiterstück zugewandte Oberfläche des Trägersubstrats an denjenigen Stellen freigelegt, die nicht von dem Halbleiterstück bedeckt sind.

Optional könnte auch die Haftschicht nicht entfernt werden, und die weitere Verarbeitung des Halbleiterstücks mit intakter Haftschicht fortgeführt werden.

Falls aus dem Halbleiterplättchen mehrere Halbleiterstücke hergestellt werden sollen, wird die lithografische Maske entsprechend so angepasst, dass diese diejenigen Bereiche der dem Trägersubstrat abgewandten Oberfläche des Halbleiterplättchens bedeckt, die jeweils eine Oberfläche eines der Halbleiterstücke bilden sollen. Durch Anpassen der lithografischen Maske kann somit die Anzahl der Halbleiterstücke und auch deren Dichte auf dem Trägersubstrat bestimmt werden. In bevorzugten Varianten des hier beschriebenen Verfahrens wird die Anzahl der Halbleiterstücke, die aus einem Halbleiterplättchen hergestellt werden sollen, so gewählt, dass möglichst wenig Material des Halbleiterplättchens verloren geht. Aus dem Halbleiterplättchen sollen entsprechend möglichst viele Halbleiterstücke hergestellt werden, wobei bei der Gestaltung der lithografischen Maske darauf geachtet werden sollte, dass der Abstand zwischen den herzustellenden Halbleiterstücken groß genug ist, so dass die Halbleiterstücke durch chemisches Ätzen an ihren Seitenflächen freigelegt werden können. Aus einem Halbleiterplättchen mit rechteckiger Grundfläche und einer Seitenlänge von 15 mm könnten z.B. 625 Halbleiterstücke mit rechteckiger Grundfläche und Seitenlängen von 500 µm hergestellt werden.

Nachdem das Halbleiterstück freigelegt wurde, wird auf das Halbleiterstück eine Schutzschicht aufgebracht (Schritt S13). Für das Aufbringen der Schutzschicht wird zunächst eine lithografische Maske auf das Halbleiterstück aufgebracht, die so gestaltet ist, dass die anschließend aufgebrachte Schutzschicht eine Öffnung aufweist, durch welche die zwischen dem Trägersubstrat und dem Halbleiterstück angeordnete Haftschicht von außen zugänglich ist.

Die Schutzschicht ist aus einem Polymer gebildet.

Die lithographische Maske ist weiterhin so gestaltet, dass die Schutzschicht eine Haltestruktur als Verankerung umfasst, die in Kontakt mit der dem Halbleiterstück zugewandten Oberfläche des Trägersubstrats ist und das Halbleiterstück auf dem Trägersubstrat verankert. Die Verankerung dient insbesondere dazu, das Halbleiterstück auf dem Trägersubstrat zu halten, wenn die zwischen dem Trägersubstrat und dem Halbleiterstück angeordnete Haftschicht entfernt wird.

Wenn das Halbleiterstück durch die Schutzschicht geschützt ist, wird die Haftschicht so weit entfernt (Schritt S14), dass das Halbleiterstück von dem Trägersubstrat mit einer Transfervorrichtung abgenommen werden kann. Zum Entfernen der Haftschicht wird Aceton verwendet. Die Haftschicht kann aber auch mittels Chloroform teilweise entfernt werden. Auch andere aprotisches Lösungsmittel sind grundsätzlich geeignet.

Anschließend wird das Halbleiterstück mit einer Transfervorrichtung von dem Trägersubstrat abgelöst (Schritt S15). Die Transfervorrichtung umfasst eine Aufnahmeschicht aus Polydimethylsiloxan (PDMS), die auf einem Glassubstrat angeordnet ist. Zum Ablösen des Halbleiterstücks wird die Aufnahmeschicht der Transfervorrichtung mit dem Halbleiterstück in Kontakt gebracht. Anschließend wird die Transfervorrichtung mit einer Geschwindigkeit, die ausreicht um eine zum Abnehmen des Halbleiterstücks ausreichende Adhäsionskraft zwischen dem Halbleiterstück und der Aufnahmeschutzschicht zu erzeugen, weg von dem Trägersubstrat bewegt. Die Transfervorrichtung wird dabei vorzugsweise nicht nur nach oben, sondern auch seitlich von dem Trägersubstrat wegbewegt.

Das Halbleiterstück wird dann auf das Zielsubstrat aufgebracht (Schritt S16), indem es mittels der Transfervorrichtung mit einer Oberfläche des Zielsubstrats in Kontakt gebracht wird. Das Zielsubstrat kann beispielsweise ein 8-Zoll, 10-Zoll oder 12-Zoll Silizium-Wafer sein. Zum Ablösen des Halbleiterstücks von der Aufnahmeschicht der Transfervorrichtung und zum Aufbringen des Halbleiterstücks auf das Zielsubstrat wird die Transfervorrichtung mit einer vergleichsweise langsameren Geschwindigkeit von dem Zielsubstrat wegbewegt. Die Geschwindigkeit wird insbesondere so gewählt, dass zwischen dem Zielsubstrat und dem Halbleiterstück wirkende van der Waals-Kräfte größer sind als die zwischen dem Halbleiterstück und der Aufnahmeschicht der Transfervorrichtung wirkende Adhäsionskraft.

Das Zielsubstrat besteht aus Silizium. Es kann aber auch aus Si₃N₄, Ge, Al₂O₃, einer Si-Schicht und Benzocyclobuten (BCB)-Schicht, oder SO₂ bestehen. Mit dem hier beschriebenen Verfahren wird somit insbesondere die Integration eines einkristallinen Halbleiterstücks, insbesondere eines III-V-Halbleiterstücks wie InP, in die Silizium-basierte CMOS-Technik möglich.

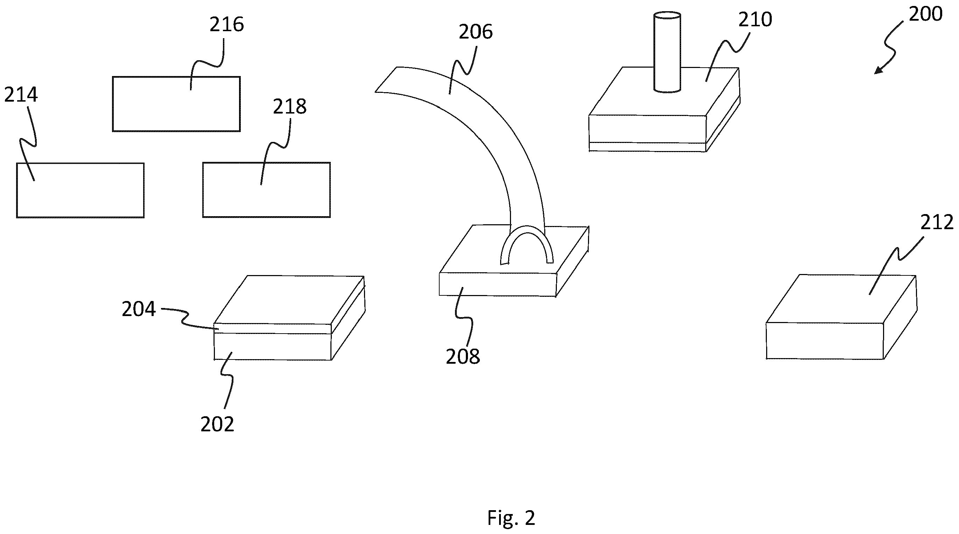

Figur 2 zeigt eine schematisch dargestellte Vorrichtung 200 zum Herstellen einer Halbleiterstruktur.

Mit der hier beschriebenen Vorrichtung kann das in Bezug auf Figur 1 beschriebene Verfahren ausgeführt werden.

Die Vorrichtung 200 umfasst ein Trägersubstrat 202 auf der eine Haftschicht 204 angeordnet ist.

Die Vorrichtung 200 umfasst weiterhin eine automatische Greifvorrichtung 206, die als Roboterarm mit einem Greifer ausgebildet sein kann, und die dazu ausgebildet ist, das Halbleiterplättchen 208 zu greifen und auf der Haftschicht 204 zu fixieren. Aus dem auf der Haftschicht 204 fixierten Halbleiterplättchen 208 kann ein Halbleiterstück oder können mehrere Halbleiterstücke hergestellt werden, die mittels der Transfervorrichtung 210 von der Haftschicht abgelöst und auf das Zielsubstrat 212 aufgebracht werden können.

Die Vorrichtung 200 umfasst eine Poliervorrichtung 214, die ausgebildet ist eine Oberfläche des Halbleiterplättchens 208 chemisch und mechanisches Polieren, sodass die polierte Oberfläche des Halbleiterplättchens 208 eine Oberflächenrauigkeit von Rₐ=10 nm oder weniger aufweist. Mit der Poliervorrichtung 214 kann auch die Schichtdicke des Halbleiterplättchens 208, nachdem seine Schichtdicke auf zwischen 100 µm und 200 µm reduziert wurde, durch mechanisches und chemisches Polieren auf eine Zielschichtdicke zwischen 5 µm und 10 µm reduziert werden.

Weiterhin umfasst die Vorrichtung 200 eine Schleifvorrichtung 216, z.B. mit einer Diamantschleifscheibe, mit der die Schichtdicke des Halbleiterplättchens 208 auf eine Dicke zwischen 100 µm und 200 µm reduziert werden kann.

Die Vorrichtung 200 umfasst weiterhin eine Lithographie-Vorrichtung 218, zum Aufbringen einer lithografischen Maske, die beispielsweise die Grundfläche eines aus dem Halbleiterplättchen 208 hergestellten Halbleiterstücks definieren kann. Die Lithographie-Vorrichtung 218 kann auch dazu verwendet werden eine lithografische Maske auf das hergestellte Halbleiterstück aufzubringen, die eine Gestaltung einer Schutzschicht definiert, die vor dem Ablösen des Halbleiterstücks mit der Transfervorrichtung 210 auf das Halbleiterstück aufgebracht wird. Die auf das Halbleiterstück aufgebrachte lithografische Maske ist insbesondere so gestaltet, dass die anschließend aufgebrachte Schutzschicht wenigstens eine Öffnung aufweist, durch die die zwischen dem Halbleiterstück und dem Trägersubstrat 202 angeordnete Schutzschicht 204 von außen zugänglich ist. Durch die Öffnung kann die Haftschicht 204 mittels eines Ätzmittels oder eines Lösungsmittels wenigstens teilweise entfernt werden, bevor das Halbleiterstück mit der Transfervorrichtung 210 von der Haftschicht 204 abgelöst und auf das Zielsubstrat 212 transferiert wird.

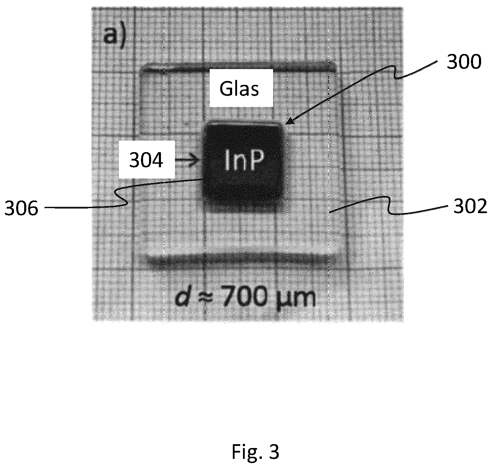

Figur 3 zeigt eine fotographische Abbildung eines Halbleiterplättchens 300 aus InP mit einer Dicke von 700 µm auf einem Trägersubstrat 302 aus Glas, wobei die dem Trägersubstrat abgewandte Oberfläche des Halbleiterplättchens chemisch und mechanisch poliert wurde. Das Halbleiterplättchen 300 ist mittels einer Haftschicht 304 aus Wachs auf dem Trägersubstrat 302 fixiert. Die dem Trägersubstrat 302 abgewandte Oberfläche 306 des Halbleiterplättchens 300 wurde mechanisch und chemisch poliert, sodass die Oberfläche 306 eine Oberflächenrauigkeit von weniger als 10 nm aufweist.

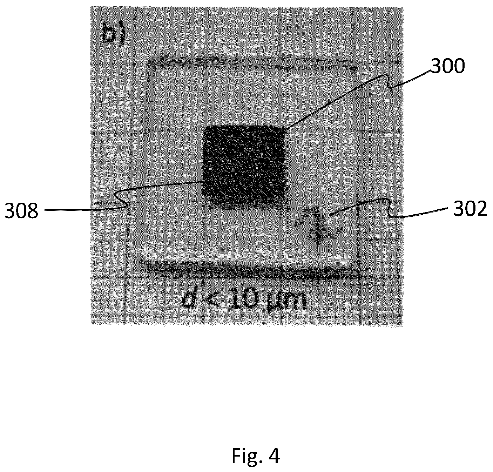

Figur 4 zeigt eine fotographische Abbildung des in Bezug auf Figur 3 beschriebenen Halbleiterplättchens 300, nachdem dieses umgedreht, die Schichtdicke bis auf weniger als 10 µm reduziert und die nach dem Umdrehen dem Trägersubstrat 302 abgewandte Oberfläche 308 des Halbleiterplättchens 300 chemisch und mechanisch poliert wurde. Das Halbleiterplättchen 300 weist somit bereits die Zielschichtdicke auf, sodass aus dem Halbleiterplättchen 300 eines oder mehrere Halbleiterstücke hergestellt werden können.

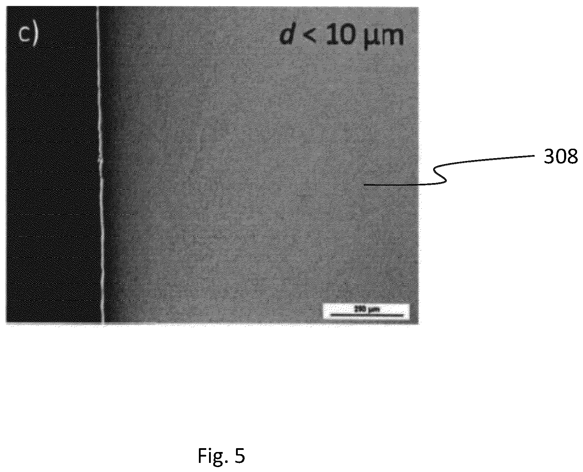

Figur 5 zeigt in einer mikroskopischen Abbildung einen Ausschnitt der Oberfläche 308 des in Figur 4 gezeigten Halbleiterplättchens 300. Anhand der mikroskopischen Abbildung lässt sich erkennen, dass die chemisch und mechanisches polierte Oberfläche 308 eine sehr glatte Oberfläche mit einer Oberflächenrauigkeit von weniger als 10 nm aufweist.

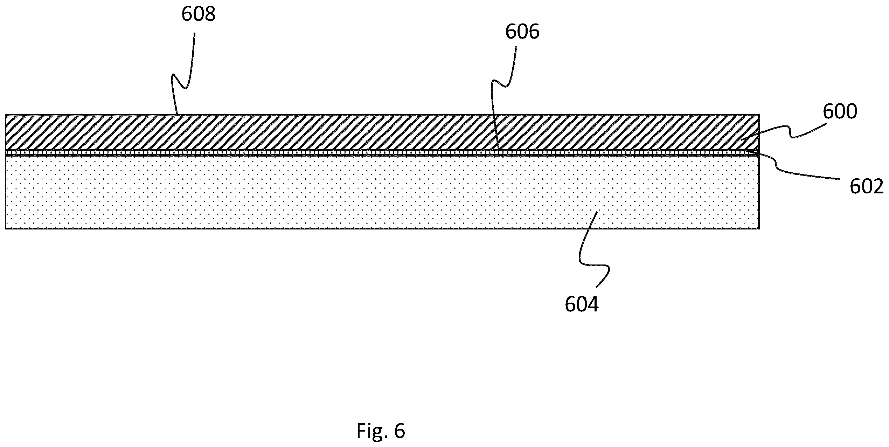

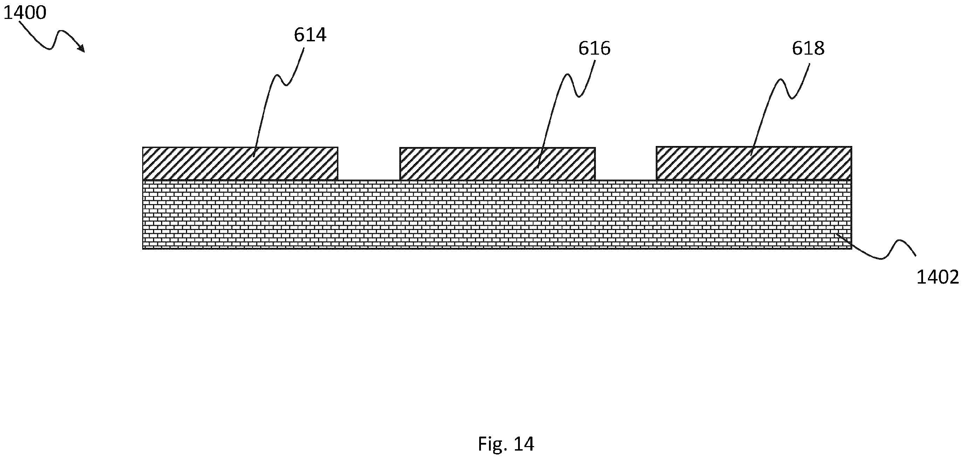

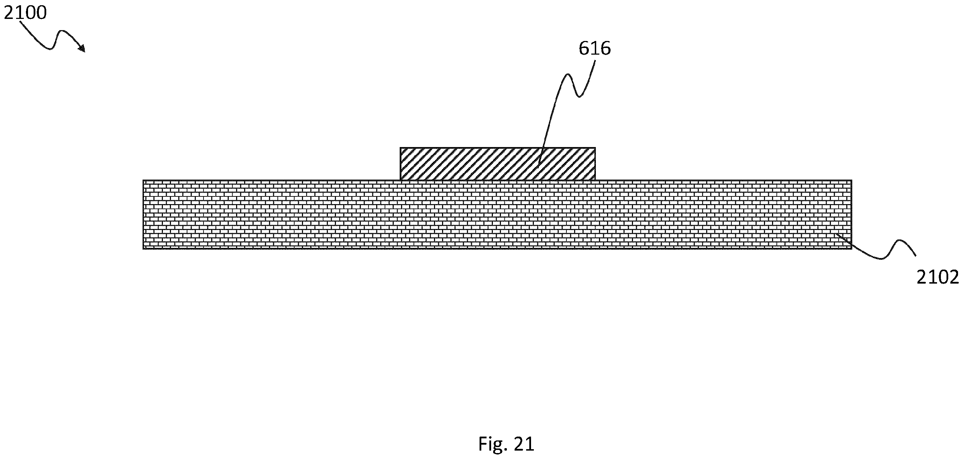

Figuren 6 bis 13 zeigen jeweils unterschiedliche Halbleiter-Zwischenprodukte, die zeitlich aufeinanderfolgend beim Durchführen eines Verfahrens zum Herstellen einerwie in Bezug auf Figur 14 beschriebenen Halbleiterstruktur hergestellt werden. Die Figuren 6, 7, und 15 bis 20 zeigen ebenfalls unterschiedliche Halbleiter-Zwischenprodukte, die zeitlich aufeinanderfolgend beim Durchführen eines Verfahrens zum Herstellen einer wie in Bezug auf Figur 21 beschriebenen Halbleiterstruktur hergestellt werden. Es handelt sich hierbei um zwei alternative Verfahren mit denen jeweils eine Halbleiterstruktur umfassend ein Zielsubstrat und wenigstens ein Halbleiterstück hergestellt werden kann.

Die beiden Verfahren unterscheiden sich insbesondere dadurch, dass in dem anhand der Halbleiter-Zwischenprodukte der Figuren 6 bis 13 nachempfundenen Verfahren die Haftschicht in Bereichen zwischen den Halbleiterstücken entfernt wird, wohingegen in dem anhand der Halbleiter-Zwischenprodukte der Figuren 6, 7 und 15 bis 20 nachempfundenen Verfahren die Haftschicht zunächst nicht entfernt wird, und die Halbleiterstücke mit intakter Haftschicht hergestellt werden.

Die nachfolgend beschriebenen Zwischenprodukte beider, alternativer Verfahren können beispielsweise während des in Bezug auf Figur 1 beschriebenen Verfahrens zum Herstellen einer Halbleiterstruktur zeitlich aufeinanderfolgend hergestellt werden. Zum Herstellen der in Bezug auf die Figuren 6 bis 13 und 15 bis20 beschriebenen Halbleiter-Zwischenprodukte und der in Bezug auf die Figuren 14 und 21 beschriebenen Halbleiterstrukturen kann beispielsweise die in Bezug auf Figur 2 beschriebene Vorrichtung verwendet werden.

In Figur 6 ist schematisch und beispielhaft ein III-V-Halbleiterplättchen 600 in einer Seitenansicht gezeigt, das mittels einer Haftschicht 602 aus Wachs oder Harz auf einem Trägersubstrat 604 aus Glas fixiert ist. Das III-V-Halbleiterplättchen 600 hat eine rechteckige Grundfläche mit Seitenlängen von 10 mm. Die Grundfläche des Trägersubstrats 604 ist größer als die des III-V-Halbleiterplättchens 600, sodass das Trägersubstrat 604 nur ausschnittsweise gezeigt ist und das III-V-Halbleiterplättchen 600 eigentlich mittig auf dem Trägersubstrat 604 angeordnet ist. Das III-V-Halbleiterplättchen 600 weist bereits die Zielschichtdicke von 10 µm oder weniger auf. Insbesondere dann, wenn das III-V-Halbleiterplättchen 600 aus einem Halbleiterwafer mit einer typischerweise deutlich größeren Schichtdicke hergestellt wurde, wurde die Schichtdicke des III-V-Halbleiterplättchens 600 also bereits durch Schleifen und mechanisches und chemisches Polieren auf die Zielschichtdicke reduziert. Weiterhin weist das III-V-Halbleiterplättchen 600 an seiner dem Trägersubstrat 604 zugewandten Oberfläche 606 sowie an seiner dem Trägersubstrat 604 abgewandten Oberfläche 608 jeweils eine Oberflächenrauigkeit von weniger als 10 nm auf. Die Oberflächen 606 und 608 wurden also bereits mit einer Poliervorrichtung mechanisch und chemisch poliert.

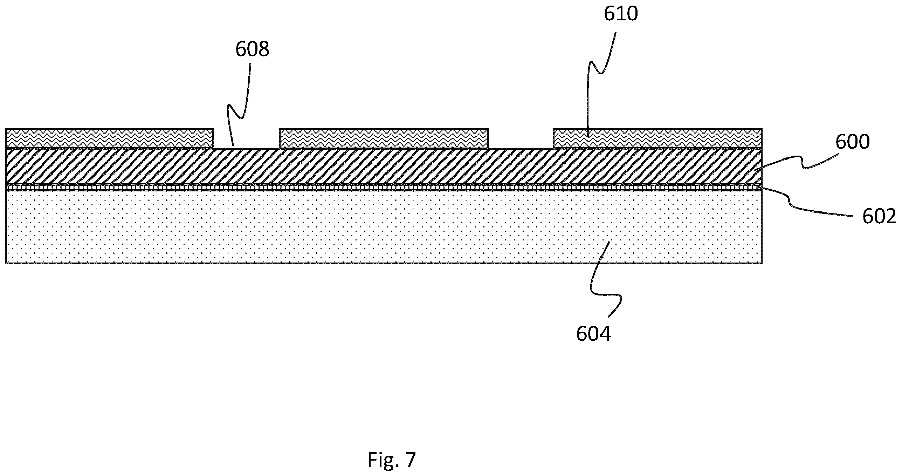

Auf die dem Trägersubstrat 604 abgewandte Seite 608 des III-V-Halbleiterplättchens 600 wird zur Herstellung von Halbleiterstücken aus dem III-V-Halbleiterplättchen 600 eine lithografische Maske 610 aufgebracht. Das so hergestellte Halbleiter-Zwischenprodukt ist schematisch und beispielhaft in Figur 7 gezeigt. Figur 7 zeigt das III-V-Halbleiterplättchen 600 in einer Seitenansicht, das mittels der Haftschicht 602 aus Wachs oder Harz auf dem Trägersubstrat 604 aus Glas fixiert ist. Die auf dem III-V-Halbleiterplättchen 600 aufgebrachte lithographische Maske 610 gibt die die Größe der herzustellenden Halbleiterstücke vor. Die lithographische Maske 610 kann z.B. aus Fotolack bestehen. Die von der lithografischen Maske 610 bedeckten Bereiche haben eine rechteckige Grundfläche von 200 µm mal 500 µm, so dass durch anisotropes Ätzen des III-V-Halbleiterplättchen 600 Halbleiterstücke mit einer Grundfläche von 200 µm mal 500 µm hergestellt werden können.

Für das anisotrope chemische Ätzen verbleibt der Fotolack auf dem III-V-Halbleiterplättchen 600. Die nicht von dem Fotolack bedeckten Bereiche des III-V-Halbleiterplättchens 600 werden durch das anisotrope chemische Ätzen entfernt, genauso wie die darunterliegenden Bereiche der Haftschicht 602. Nach dem anisotropen chemischen Ätzen liegen also die Bereiche der dem III-V-Halbleiterplättchen zugewandten Oberfläche 612 des Trägersubstrats 604, auf denen kein Halbleiterstück angeordnet ist, frei.

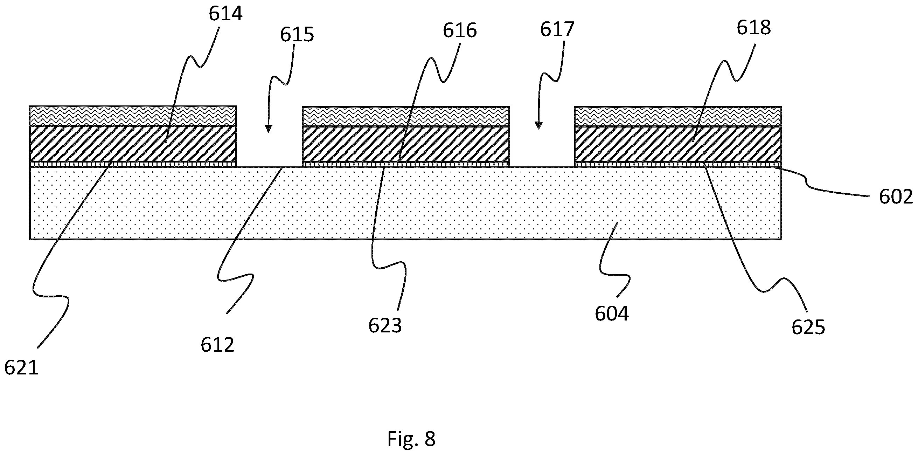

In Bezug auf die Figuren 8 bis 13 werden nachfolgend Halbleiter-Zwischenprodukte beschrieben, die in einem Verfahren hergestellt werden, in dem die Haftschicht 602 in Bereichen zwischen den Halbleiterstücken 614, 616, 618 mittels eines Lösungsmittels entfernt wird. Ein Entfernen der Haftschicht 602 zwischen den Halbleiterstücken 614, 616, 618 mittels eines Lösungsmittels hat den Vorteil, dass alle Halbleiterstücke 614, 616, 618 von dem Trägersubstrat gelöst und gemeinsam mittels einer Transfervorrichtung auf ein Zielsubstrat transferiert werden können. Es ist also mit einer vergleichsweise hohen Ausbeute an Halbleiterstücken zu rechnen.

Wie in Figur 8 schematisch und beispielhaft gezeigt, werden durch das anisotrope chemische Ätzen drei III-V-Halbleiterstücke 614, 616, 618 an ihren Seitenflächen freigelegt. Die Haftschicht 602 dient dabei zunächst als Ätz-Stopp. In einem weiteren Schritt wird die Haftschicht 602 in Bereichen 615, 617 zwischen den III-V-Halbleiterstücken 614, 616, 618 mittels eines Lösungsmittels entfernt. Die in Figur 8 in einer Seitenansicht gezeigten III-V-Halbleiterstücke 614, 616, 618 werden somit durch anisotropes chemisches Ätzen des III-V-Halbleiterplättchens 600 hergestellt und sind weiterhin mittels den nach dem anisotropen chemischen Ätzen übrig gebliebenen Bereichen 621, 623, 625 der Haftschicht 602 auf dem Trägersubstrat 604 aus Glas fixiert.

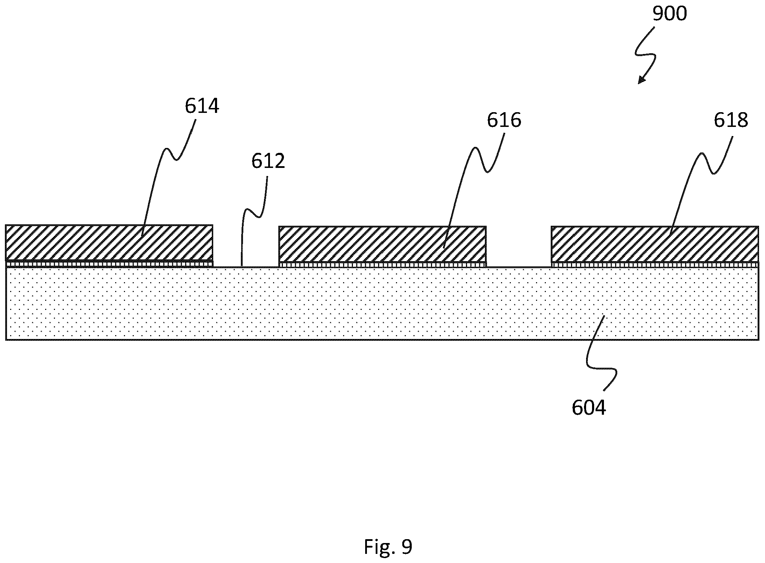

Bei dem in Figur 9 schematisch und beispielhaft gezeigten Halbleiter-Zwischenprodukt 900 wurde die wie in Bezug auf Figur 8 beschriebene lithographische Maske 610 entfernt. Die III-V-Halbleiterstücke 614, 616, 618 liegen an ihrer dem Trägersubstrat 604 abgewandten Oberfläche sowie an ihren Seitenflächen, die senkrecht zu der Oberfläche 612 des Trägersubstrats 604 stehen, frei.

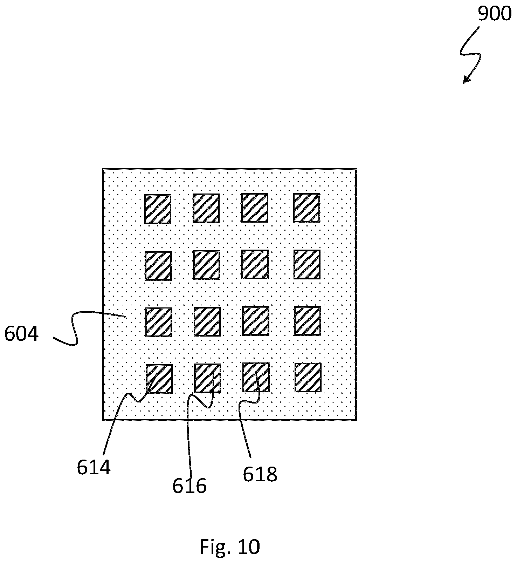

Figur 10 zeigt schematisch und beispielhaft das in Bezug auf Figur 9 beschriebene Halbleiter-Zwischenprodukt 900 umfassend ein Trägersubstrat 604 auf dem mittels einer Haftschicht mehrere III-V-Halbleiterstücke fixiert sind in einer Draufsicht. Wie anhand der Fig. 10 erkennbar ist, ist die Oberfläche des Trägersubstrats 604 an denjenigen Stellen, an denen sich keines der III-V-Halbleiterstücke befindet, freigelegt. Von den mehreren III-V-Halbleiterstücken sind die III-V-Halbleiterstücke 614, 616, 618 beispielhaft in der Figur 9 gezeigt. Auch die hier gezeigte Anzahl an III-V-Halbleiterstücken ist als lediglich beispielhaft anzusehen. Aus einem Halbleiterplättchen mit Seitenlängen von 10 mm werden vorzugsweise mehrere hundert Halbleiterstücke mit einer Grundfläche von beispielweise 200 µm mal 500 µm hergestellt.

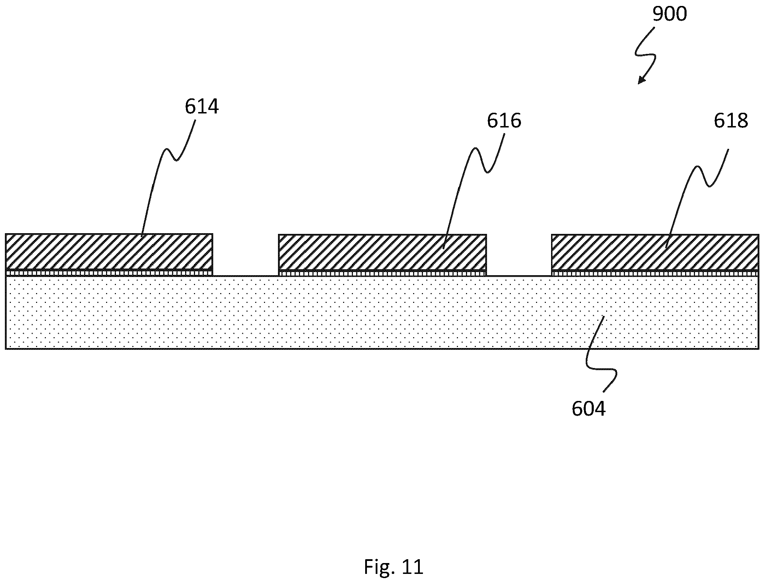

Figur 11 zeigt schematisch und beispielhaft das Halbleiter-Zwischenprodukt 900, wie es vorstehend in Bezug auf Figur 9 beschrieben wurde, umfassend ein Trägersubstrat 604 auf dem mittels einer Haftschicht 602 die III-V-Halbleiterstücke 614, 616, 618 fixiert sind, in einer Seitenansicht. Das Halbleiter-Zwischenprodukt 900 kann unmittelbar oder zu einem späteren Zeitpunkt an einem anderen Ort so weiterbearbeitet werden, dass eines oder mehrere der III-V-Halbleiterstücke 614, 616, 618 von dem Trägersubstrat 604 abgelöst und auf ein Zielsubstrat übertragen werden. Für das Ablösen und Transferieren des einen oder der mehreren III-V-Halbleiterstücke 614, 616, 618 wird eine Transfervorrichtung verwendet, die eine auf einem Glassubstrat angeordnete Aufnahmeschicht aus PDMS umfasst. Die Transfervorrichtung kann ausgebildet sein, selektiv eines der mehreren III-V-Halbleiterstücke 614, 616, 618 abzulösen und auf das Zielsubstrat aufzubringen. Alternativ kann die Transfervorrichtung ausgebildet sein mehrere oder sogar alle auf dem Trägersubstrat 604 angeordneten Halbleiterstücke gleichzeitig abzulösen und gleichzeitig auf ein Zielsubstrat oder, wie es bevorzugt ist, auf mehrere, entsprechend komplementär zu der Anordnung der Halbleiterstücke auf der Transfervorrichtung angeordnete Zielsubstrate aufzubringen. Dadurch kann die Herstellung mehrerer Halbleiterstrukturen parallelisiert und das Verfahren somit besonders effizient durchgeführt werden.

Bevor die III-V-Halbleiterstücke 614, 616, 618 von dem Trägersubstrat 604 abgelöst werden können, wird die Haftschicht zwischen den jeweiligen III-V-Halbleiterstücken 614, 616, 618 und dem Trägersubstrat entfernt. Zum Entfernen der Haftschicht wird vorzugsweise ein Lösungsmittel wie Aceton oder Chloroform verwendet.

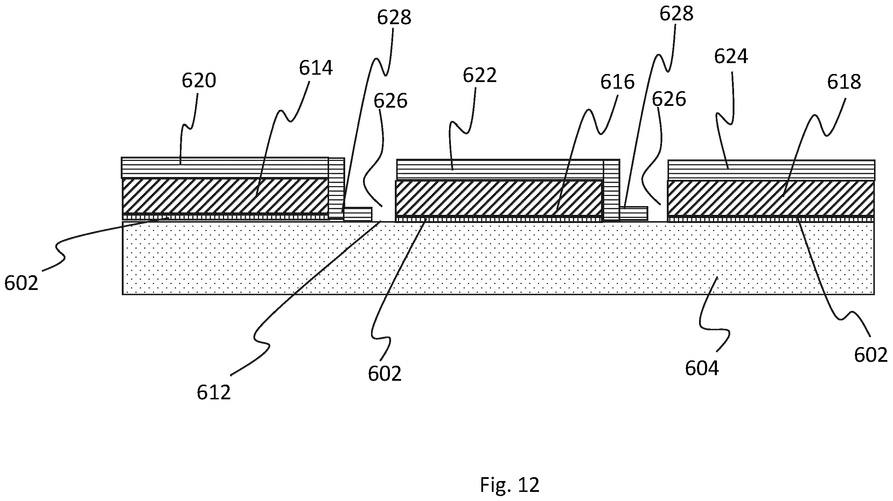

Wie in Figur 12 schematisch und beispielhaft gezeigt, wird das in Bezug auf Figur 11 beschriebene Halbleiter-Zwischenprodukt 900 so weiterverarbeitet, dass auf die III-V-Halbleiterstücken 614, 616, 618 jeweils eine Schutzschicht 620, 622, 624 aufgebracht wird. Die Schutzschicht 620, 622, 624 besteht vorzugsweise aus einem Polymer.

Wie beispielhaft in Figur 12 dargestellt, bedeckt die Schutzschicht 620, 622, 624 jeweils eines der III-V-Halbleiterstücke 614, 616, 618 auf seiner dem Trägersubstrat 604 abgewandten Oberfläche. Bevor jedoch die Schutzschicht 614,6 116,618 aufgebracht wird, wird auf jedes der III-V-Halbleiterstücken 614, 616, 618 eine lithografische Maske aufgebracht, die so gestaltet ist, dass die jeweils auf die III-V-Halbleiterstücke 614, 616, 618 aufgebrachten Schutzschichten 620, 622, 624 eine Öffnung 626 und eine Haltestruktur als Verankerung 628 umfassen. Die Öffnung 626 ist so gestaltet, dass durch die Öffnung 626 die zwischen dem jeweiligen der III-V-Halbleiterstücke 614, 616, 618 und dem Trägersubstrat 604 angeordnete Haftschicht 602 von außen zugänglich bleibt. Die Verankerung 628 der Schutzschichten 620, 622, 624 ist so angeordnet, dass diese mit der den III-V-Halbleiterstücken 614, 616, 618 zugewandten Oberfläche 612 das Trägersubstrat 604 in Kontakt ist. Die Verankerung 628 dient dazu, dass jeweilige III-V-Halbleiterstücken 614, 616, 618 auf dem Trägersubstrat 604 zu halten, wenn die Haftschicht 602 entfernt wird. Die Verankerung 628 dient insbesondere als Sollbruchstelle.

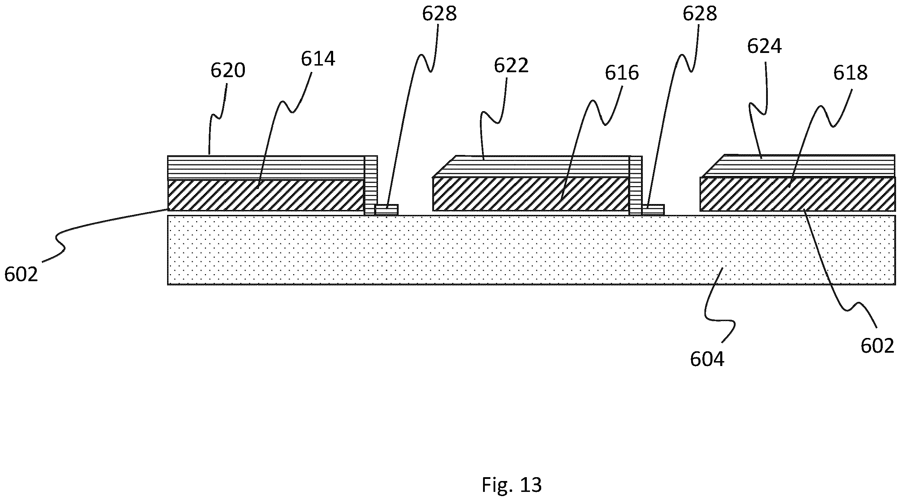

Figur 13 zeigt schematisch und beispielhaft das in Bezug auf Figur 12 beschriebene Halbleiter-Zwischenprodukt, wobei die Haftschicht 602 zwischen den III-V-Halbleiterstücken 614, 616, 618 und dem Trägersubstrat 604 jeweils mittels eines Ätzmittels oder Lösungsmittels wie Aceton oder Chloroform vollständig entfernt wurde. Die Schutzschichten 620, 622, 624 verbleiben dabei weiterhin auf den III-V-Halbleiterstücken 614, 616, 618. Da nun die Haftschicht 602 zwischen den jeweiligen III-V-Halbleiterstücken 614, 616, 618 und dem Trägersubstrat 604 vollständig entfernt wurde, werden die III-V-Halbleiterstücke 614, 616, 618 nur noch mittels der Verankerungen 628 auf dem Trägersubstrat 604 gehalten. Die III-V-Halbleiterstücken 614, 616, 618 können nun mit einer Transfervorrichtung abgelöst und auf ein Zielsubstrat transferiert werden. Zum Ablösen der III-V-Halbleiterstücke 614, 616, 618 mit einer Transfervorrichtung werden die Verankerungen 628 mechanisch durch das Abnehmen der III-V-Halbleiterstücke 614, 616, 618 von dem Trägersubstrat 604 mit der Transfervorrichtung durchgetrennt.

Durch Transferieren der III-V-Halbleiterstücke 614, 616, 618 mit einer Transfervorrichtung auf das Zielsubstrat kann die in Bezug auf Figur 14 beschriebene Halbleiterstruktur 1400 hergestellt werden.

Die Halbleiterstruktur 1400 weist ein Zielsubstrat 1402 auf. Auf dem Zielsubstrat 1402 sind die III-V-Halbleiterstücke 614, 616, 618 angeordnet. Die Schutzschichten 620, 622, 624 wurden bereits entfernt, so dass die Halbleiterstruktur 1400 weiterverarbeitet werden kann, z.B. zu einem Halbleiterbauteil oder zu einer mikroelektronischen Schaltung. Die Halbleiterstruktur 1400 ist als lediglich beispielhaft anzusehen. Tatsächlich können auf eine Halbleiterstruktur mehrere Hundert III-V-Halbleiterstücke aufweisen, die nacheinander oder gleichzeitig mittels einer Transfervorrichtung auf das Zielsubstrat aufgebracht wurden. Die Halbleiterstruktur 1400 kann zu einer Vielzahl unterschiedlicher Halbleiterbauteile oder mikroelektronischen Schaltungen weiterverarbeitet werden.

Ausgehend von dem in Bezug auf die Figur 7 beschriebenen Halbleiter-Zwischenprodukt kann das Halbleiter-Zwischenprodukt alternativ auch so weiterverarbeitet werden, dass die Haftschicht 602 nicht wie in Bezug auf Fig. 8 beschrieben zwischen den III-V-Halbleiterstücken 614, 616, 618 entfernt wird. In einem solchen alternativen Verfahren bleibt die Haftschicht 602 also zwischen den III-V-Halbleiterstücken 614, 616, 618 intakt und wird erst vor dem Ablösen des III-V-Halbleiterstücks 616entfernt.

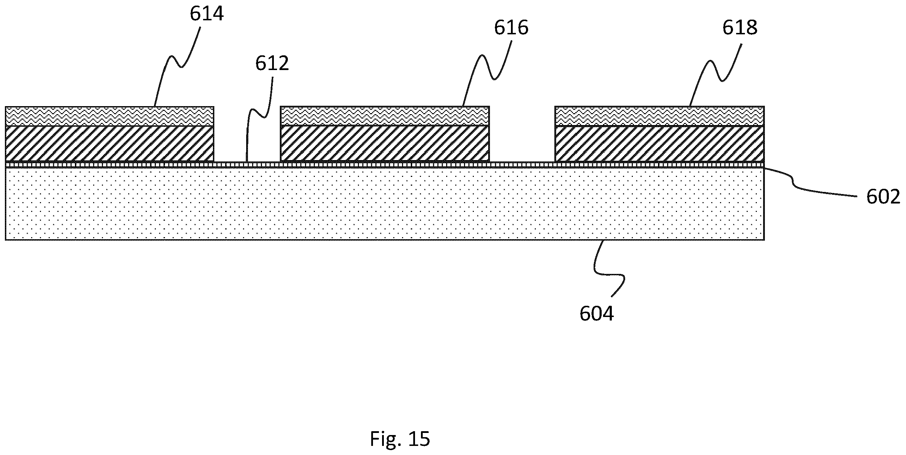

Halbleiter-Zwischenprodukte eines solchen alternativen Verfahrens werden ausgehend von den Halbleiter-Zwischenprodukten der Figuren 6 und 7 nachfolgend in Bezug auf die Figuren 15 bis 20 beschrieben. Anhand der in Bezug auf die Figuren 6 und 7 und 15 bis 20 beschriebenen Halbleiter-Zwischenprodukte kann das alternative Verfahren zum Herstellen einer wie in Bezug auf Fig. 21 beschriebenen Halbleiterstruktur nachempfunden werden.

Figur 15 zeigt schematisch und beispielhaft das in Bezug auf Fig. 7 beschriebene Zwischenprodukt, wobei durch anisotropes chemisches Ätzen drei III-V-Halbleiterstücke 614, 616, 618 an ihren Seitenflächen freigelegt sind. Die Haftschicht 602 dient als Ätz-Stopp. Im Gegensatz zu dem in Bezug auf Fig. 8 beschriebenen Halbleiter-Zwischenprodukt wurde die Haftschicht in Bereichen zwischen den III-V-Halbleiterstücke 614, 616, 618 nicht mittels eines Lösungsmittels entfernt, sondern das Halbleiter-Zwischenprodukt wird mit vollständig intakter Haftschicht 602 weiterverarbeitet.

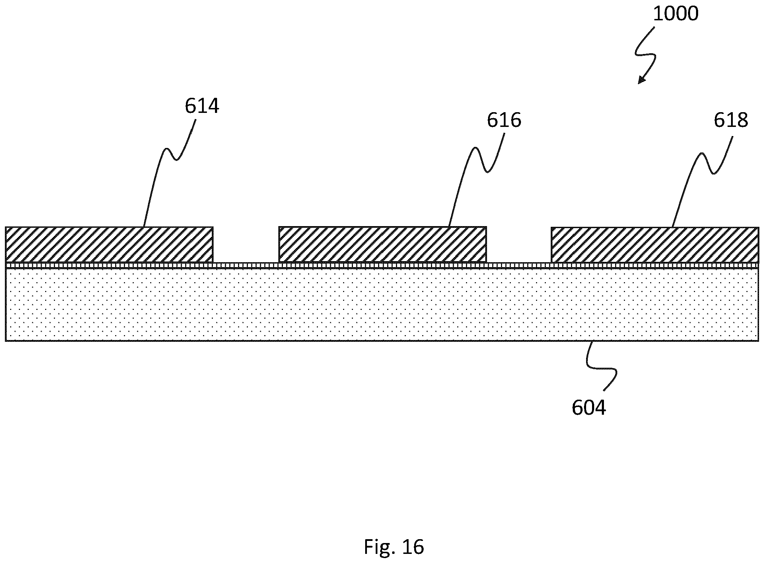

Bei dem in Figur 16 schematisch und beispielhaft gezeigten Halbleiter-Zwischenprodukt 1000 wurde die wie in Bezug auf Figur 7 beschriebene lithographische Maske 610 entfernt. Die III-V-Halbleiterstücke 614, 616, 618 liegen an ihrer dem Trägersubstrat 604 abgewandten Oberfläche sowie an ihren Seitenflächen, die senkrecht zu der Oberfläche 612 des Trägersubstrats 604 stehen, frei.

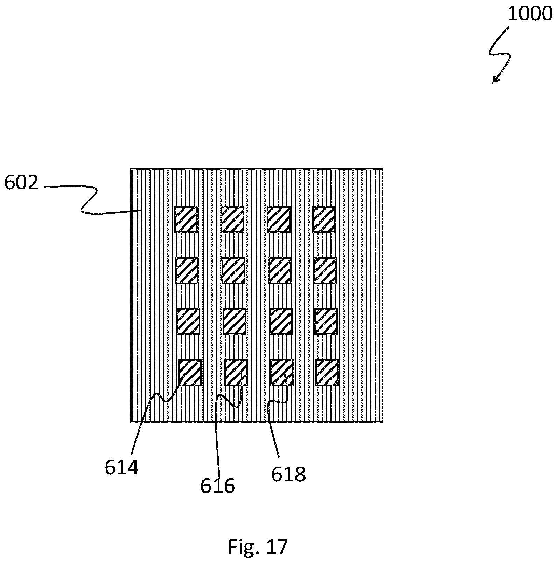

Figur 17 zeigt schematisch und beispielhaft das in Bezug auf Figur 16 beschriebene Halbleiter-Zwischenprodukt 1000 umfassend ein Trägersubstrat 604 auf dem mittels einer Haftschicht 602 mehrere III-V-Halbleiterstücke fixiert sind in einer Draufsicht. Wie anhand der Figur 16 erkennbar ist, ist die Haftschicht 602 an denjenigen Stellen, an denen sich keines der III-V-Halbleiterstücke befindet, freigelegt. Im Gegensatz zu dem in Bezug auf Figur 10 beschriebenen Halbleiter-Zwischenprodukt 900 ist bei dem Halbleiter-Zwischenprodukt 1000 in der Draufsicht nicht das Trägersubstrat 604 zu erkennen, sondern die Haftschicht 602. Von den mehreren III-V-Halbleiterstücken sind die III-V-Halbleiterstücke 614, 616, 618 beispielhaft in der Figur 16 gezeigt. Auch die hier gezeigte Anzahl an III-V-Halbleiterstücken ist als lediglich beispielhaft anzusehen. Aus einem Halbleiterplättchen mit Seitenlängen von 10 mm werden vorzugsweise mehrere hundert Halbleiterstücke mit einer Grundfläche von beispielweise 200 µm mal 500 µm hergestellt.

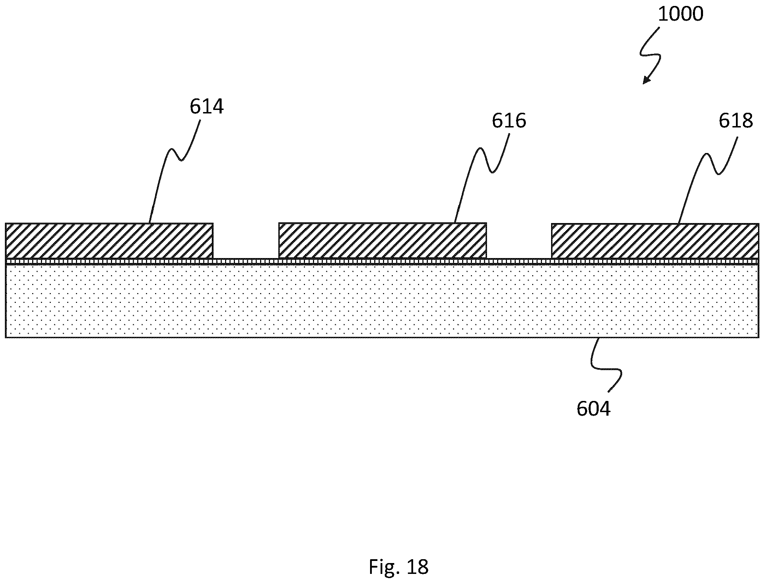

Figur 18 zeigt schematisch und beispielhaft das Halbleiter-Zwischenprodukt 1000, wie es vorstehend in Bezug auf Figur 17 beschrieben wurde, umfassend ein Trägersubstrat 604 auf dem mittels einer Haftschicht 602 die III-V-Halbleiterstücke 614, 616, 618 fixiert sind, in einer Seitenansicht. Die III-V-Halbleiterstücke 614, 616, 618 können wie vorstehend mit Bezug auf Figur 11 beschrieben mittels einer Transfervorrichtung abgelöst werden.

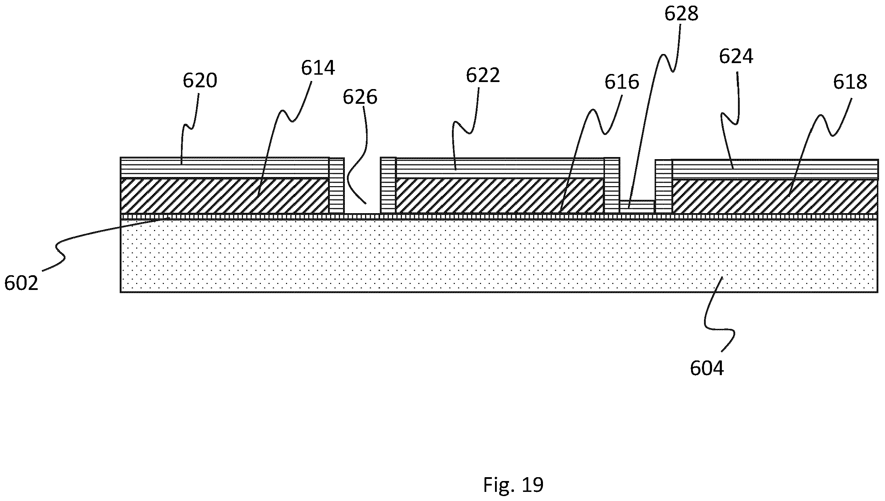

Wie in Figur 19 schematisch und beispielhaft gezeigt, wird das in Bezug auf Figur 18 beschriebene Halbleiter-Zwischenprodukt 1000 so weiterverarbeitet, dass auf die III-V-Halbleiterstücken 614, 616, 618 jeweils eine Schutzschicht 620, 622, 624 aufgebracht wird. Die Schutzschicht 620, 622, 624 besteht vorzugsweise aus einem Polymer.

Wie beispielhaft in Figur 19 dargestellt, bedeckt die Schutzschicht 620, 622, 624 jeweils eines der III-V-Halbleiterstücke 614, 616, 618 auf seiner dem Trägersubstrat 604 abgewandten Oberfläche. Bevor jedoch die Schutzschicht 614,6 116,618 aufgebracht wird, wird eine lithografische Maske aufgebracht, die so gestaltet ist, dass die jeweils auf die III-V-Halbleiterstücke 614, 616, 618 aufgebrachten Schutzschichten 620, 622, 624 eine Öffnung 626 und eine Haltestruktur als Verankerung 628 umfassen. Die Öffnung 626 ist so gestaltet, dass durch die Öffnung 626 die zwischen dem III-V-Halbleiterstück 616 und dem Trägersubstrat 604 angeordnete Haftschicht 602 von außen zugänglich bleibt. Die Verankerung 628 der Schutzschicht 622 ist so angeordnet, dass diese die Schutzschichten 622 und 624 miteinander verbindet und mit ihrer den III-V-Halbleiterstücken 614, 616, 618 zugewandten Oberfläche der Haftschicht 602 in Kontakt ist. Die Verankerung 628 dient dazu, dass jeweilige III-V-Halbleiterstücken 614, 616, 618 auf dem Trägersubstrat 604 zu halten und insbesondere als Sollbruchstelle beim Ablösen das III-V-Halbleiterstücks 616.

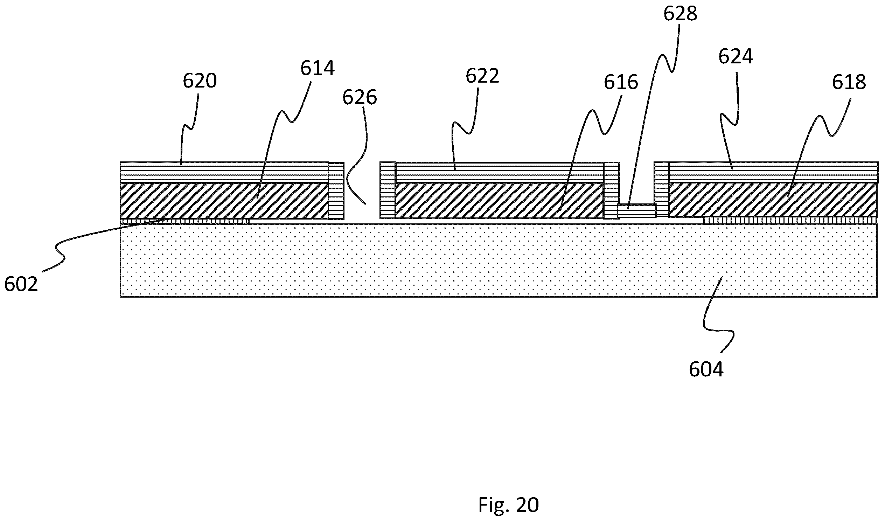

Figur 20 zeigt schematisch und beispielhaft die drei III-V-Halbleiterstücke 614, 616, 618 auf dem Trägersubstrat 604, wobei die Haftschicht 602 unter dem mittleren III-V-Halbleiterstück 616 vollständig entfernt wurde. Das III-V-Halbleiterstück 616 wird nur noch durch die Verankerung 628, der auf dem III-V-Halbleiterstück 616 aufgebrachten Schutzschicht 622 gehalten, und kann mit einer Transfervorrichtung von dem Trägersubstrat 604 abgelöst und auf ein Zielsubstrat transferiert werden. Die Verankerung 628 verbindet insbesondere die Schutzschichten 622 und 624. Die Verankerung 628 schließt dabei in Richtung des Trägersubstrats 604 bündig mit der dem Trägersubstrat 604 zugewandten Oberfläche des III-V-Halbleiterstücks 616 ab. Der Abstand zwischen Trägersubstrat 604 und III-V-Halbleiterstück 616 ist somit auch nach dem Entfernen der Haftschicht 602 im Wesentlichen identisch zu dem Abstand zwischen Verankerung 628 und Trägersubstrat 604. Dies hat den Vorteil, dass nach dem Ablösen des III-V-Halbleiterstücks 616 mittels der Transfervorrichtung keine Bruchkanten der Verankerung 628 in die zuvor dem Trägersubstrat zugewandte Richtung hervorstehen. Das III-V-Halbleiterstück 616 kann somit plan auf ein Zielsubstrat aufgebracht werden, ohne dass Reste der Verankerung 628 das III-V-Halbleiterstück 616 relativ zu der Oberfläche des Zielsubstrats anheben würden.

Da die Verankerung 628 nicht mit dem Trägersubstrat 604 in Kontakt ist und das III-V-Halbleiterstück 616 nach dem Entfernen der dazwischenliegenden Haftschicht 602 allein durch den Kontakt der Verankerung 628 mit der Schutzschicht 624 des benachbarten III-V-Halbleiterstücks 618 auf dem Trägersubstrat 604 gehalten wird, ist es bevorzugt, wenn die Haftschicht 602 zwischen dem benachbarten III-V-Halbleiterstücks 618 und dem Trägersubstrat 604 nicht vollständig entfernt wird. Das benachbarte III-V-Halbleiterstück 618 wird dann immer noch mittels Haftschicht 602 auf dem Trägersubstrat 604 gehalten. Das abzulösende III-V-Halbleiterstück 616 wird somit mittelbar über den Kontakt der Verankerung 628 mit dem benachbarten III-V-Halbleiterstück 618 auf dem Trägersubstrat 604 gehalten.

Das Ablösen des III-V-Halbleiterstücks 616 erfolgt durch mechanisches Durchtrennen der Verankerung 628 durch Abheben des III-V-Halbleiterstücks 616 von dem Trägersubstrat 604 mit der Transfervorrichtung.

Falls auf dem Trägersubstrat 604 mehrere III-V-Halbleiterstücke, z.B. mehrere hundert III-V-Halbleiterstücke, vorhanden sind, können die auf den III-V-Halbleiterstücken angeordneten Schutzschichten so gestaltet sein, dass jeweils die Verankerung eines III-V-Halbleiterstücks mit der Schutzschicht eines benachbarten III-V-Halbleiterstücks verbunden ist. Mittels eines Lösungsmittels kann dann die Haftschicht jeweils unter einem dieser über die Verankerung miteinander verbundenen III-V-Halbleiterstücke entfernt werden. Dadurch entstehen eine Anzahl Paare von III-V-Halbleiterstücken von denen jeweils ein III-V-Halbleiterstück von dem Trägersubstrat abgelöst ist und durch das benachbarte III-V-Halbleiterstück über die Verankerung mittels der Haftschicht auf dem Trägersubstrat gehalten wird.

Die Transfervorrichtung ist in diesem Fall vorzugsweise so gestaltet, dass deren Aufnahmeschicht eine Noppenstruktur aufweist, die so ausgebildet ist, dass die Noppen mit jeweils von dem Trägersubstrat gelösten III-V-Halbleiterstücken in Kontakt gebracht werden kann.

Mit der Transfervorrichtung können dann die von dem Trägersubstrat gelösten III-V-Halbleiterstücke abgenommen und auf das Zielsubstrat transferiert werden.

Figur 21 zeigt eine Halbleiterstruktur 2100 aufweisend ein Zielsubstrat 2102 und ein auf das Zielsubstrat 2002 aufgebrachtes III-V-Halbleiterstück 616. Von dem III-V-Halbleiterstück 616 wurde eine zuvor vorhandene Schutzschicht bereits entfernt. Auch die Halbleiterstruktur 2100 ist als lediglich beispielhaft anzusehen. Die Halbleiterstruktur 2100 kann mehrere Hundert III-V-Halbleiterstücke aufweisen. Jedoch werden gemäß dem vorstehend beschriebenen Verfahren nicht alle auf dem Trägersubstrat vorhandenen III-V-Halbleiterstücke auf das Zielsubstrat transferiert, sondern nur diejenigen III-V-Halbleiterstücke, die vollständig von dem Trägersubstrat gelöst wurden. Diejenigen III-V-Halbleiterstücke, die weiterhin durch die Haftschicht auf dem Trägersubstrat fixiert sind und mittels der Verankerung benachbarte, vollständig gelöste III-V-Halbleiterstücke auf dem Trägersubstrat halten, verbleiben weiterhin auf dem Trägersubstrat und werden nicht auf das Zielsubstrat transferiert. Die Transfervorrichtung ist insbesondere so ausgebildet, dass diese gerade die von dem Trägersubstrat gelösten III-V-Halbleiterstücke aufnehmen kann. Die Transfervorrichtung weist dafür insbesondere eine entsprechend ausgebildete Aufnahmeschicht mit Noppenstruktur auf. Die Halbleiterstruktur 2100 kann zu einer Vielzahl unterschiedlicher Halbleiterbauteile oder mikroelektronischen Schaltungen weiterverarbeitet werden.

### Bezugszeichenliste

- 200: Vorrichtung
- 202: Trägersubstrat
- 204: Haftschicht
- 206: Greifvorrichtung
- 208: Halbleiterplättchen
- 210: Transfervorrichtung
- 212: Zielsubstrat
- 214: Poliervorrichtung
- 216: Schleifvorrichtung
- 218: Lithographie-Vorrichtung
- 300: Halbleiterplättchen
- 302: Trägersubstrat
- 304: Haftschicht
- 306: dem Trägersubstrat abgewandte Oberfläche
- 308: chemisch und mechanisches polierte Oberfläche
- 600: III-V-Halbleiterplättchen
- 602: Haftschicht
- 604: Trägersubstrat
- 606: seiner dem Trägersubstrat zugewandten Oberfläche
- 608: dem Trägersubstrat abgewandten Oberfläche
- 610: lithografische Maske
- 612: dem III-V-Halbleiterplättchen zugewandten Oberfläche des Trägersubstrats
- 614: III-V-Halbleiterstück
- 616: III-V-Halbleiterstück
- 618: III-V-Halbleiterstück
- 620: Schutzschicht
- 622: Schutzschicht
- 624: Schutzschicht
- 626: Öffnung
- 628: Verankerung
- 900: Halbleiter-Zwischenprodukt
- 1000: Halbleiter-Zwischenprodukt
- 1400: Halbleiterstruktur
- 1402: Zielsubstrat
- 2100: Halbleiterstruktur
- 2102: Zielsubstrat
- S1: Bereitstellen eines Halbleiterwafer aus InP
- S2: Heraussägen eines Halbleiterplättchens aus dem Halbleiterwafer
- S3: Fixieren mittels einer Haftschicht
- S4: Herstellen eines Halbleiterstücks
- S5: chemisches und mechanisches Polieren des Halbleiterplättchens
- S6: Abnehmen des Halbleiterplättchens
- S7: Reinigen des Halbleiterplättchens
- S8: chemisches und mechanisches polieren des Halbleiterplättchens
- S9: Reduzieren der Schichtdicke des Halbleiterplättchens
- S10: Reduzieren der Schichtdicke des Halbleiterplättchens bis zur Zielschichtdicke
- S11: Aufbringen einer lithografischen Maske
- S12: anisotropes chemisches Ätzen des Halbleiterplättchens
- S13: Aufbringen einer Schutzschicht
- S14: Entfernen der Haftschicht
- S15: Ablösen des Halbleiterstücks mit der Transfervorrichtung
- S16: Aufbringen des Halbleiterstücks auf das Zielsubstrat

## Patentansprüche

1. Verfahren zum Herstellen einer Halbleiterstruktur umfassend ein Zielsubstrat und wenigstens ein auf dem Zielsubstrat angeordnetes Halbleiterstück, das vorzugsweise ein III-V-Halbleiterstück ist, wobei das Verfahren die Schritte aufweist:
- Fixieren eines einkristallinen Halbleiterplättchens, insbesondere eines III-V-Halbleiterplättchens, auf einem Trägersubstrat mittels einer Haftschicht,
- Herstellen von wenigstens einem einkristallinen Halbleiterstück aus dem Halbleiterplättchen, wobei das Halbleiterstück mittels der Haftschicht auf dem Trägersubstrat fixiert bleibt,
- Ablösen des wenigstens einen Halbleiterstücks von der Haftschicht mit einer Transfervorrichtung, und
- Aufbringen des Halbleiterstücks auf das Zielsubstrat mit der Transfervorrichtung.

2. Verfahren nach Anspruch 1, weiterhin aufweisend die Schritte:
- Bereitstellen eines einkristallinen Halbleiterwafers, der vorzugsweise ein III-V-Halbleiterwafer ist, und
- Herstellen des Halbleiterplättchens aus dem Halbleiterwafer.

3. Verfahren nach Anspruch 2, wobei das Herstellen des Halbleiterplättchens aus dem Halbleiterwafer umfasst, dass das Halbleiterplättchen mechanisch aus dem Halbleiterwafer herausgeschnitten, herausgesägt oder gebrochen, oder chemisch aus dem Halbleiterwafer herausgelöst wird.

4. Verfahren nach wenigstens einem der vorstehenden Ansprüche, wobei die Haftschicht aus einem Wachs oder einem Harz gebildet ist.

5. Verfahren nach wenigstens einem der vorstehenden Ansprüche, wobei die Haftschicht eine Schichtdicke von 2 µm oder weniger, bevorzugt zwischen 100 nm und 2 µm, insbesondere zwischen 600 nm und 1,2 µm, hat.

6. Verfahren nach wenigstens einem der vorstehenden Ansprüche, wobei das Trägersubstrat aus Glas, insbesondere aus Siliziumdioxid oder Borosilikatglas besteht.

7. Verfahren nach wenigstens einem der vorstehenden Ansprüche, wobei das Herstellen des wenigstens einen Halbleiterstücks aus dem Halbleiterplättchen umfasst, dass
- eine dem Trägersubstrat abgewandte Oberfläche des Halbleiterplättchens chemisch und/oder mechanisch poliert wird, und
- das Halbleiterplättchen von dem Trägersubstrat abgenommen und erneut auf dem Trägersubstrat mittels der Haftschicht fixiert wird, so dass die polierte Oberfläche dem Trägersubstrat zugewandt ist.

8. Verfahren nach wenigstens einem der vorstehenden Ansprüche, wobei das Herstellen des wenigstens einen Halbleiterstücks aus dem Halbleiterplättchen umfasst, dass
- eine Schichtdicke des Halbleiterstücks in Richtung des Trägersubstrats bis zu einer Zielschichtdicke von vorzugsweise 10 µm oder weniger, insbesondere zwischen 5 µm und 10 µm, reduziert wird.

9. Verfahren nach Anspruch 8, wobei das Reduzieren der Schichtdicke in zwei Schritten erfolgt, wobei
- in einem ersten Schritt die Schichtdicke durch mechanisches Schleifen auf eine Dicke zwischen 100 µm und 200 µm reduziert wird, und
- in einem zweiten Schritt die Schichtdicke durch chemisches und/oder mechanisches Polieren auf eine Dicke von 10 µm oder weniger, insbesondere zwischen 10 µm und 5 µm, reduziert wird.

10. Verfahren nach wenigstens einem der vorstehenden Ansprüche, wobei das Herstellen des wenigstens einen Halbleiterstücks aus dem Halbleiterplättchen umfasst, dass
- auf einer dem Trägersubstrat abgewandten Oberfläche des Halbleiterplättchens wenigstens eine lithografische Maske aufgebracht wird, die denjenigen Bereich auf der dem Trägersubstrat abgewandten Oberfläche des Halbleiterplättchens bedeckt, der eine Oberfläche des herzustellenden Halbleiterstücks bilden soll, und
- das wenigstens eine Halbleiterstück an seinen Seitenflächen durch anisotropes chemisches Ätzen des Halbleiterplättchens in Richtung des Trägersubstrats freigelegt wird und durch die Haftschicht auf dem Trägersubstrat fixiert bleibt.

11. Verfahren nach wenigstens einem der vorstehenden Ansprüche, wobei vor dem Ablösen des wenigstens einen Halbleiterstücks von der Haftschicht und dem Trägersubstrat mit der Transfervorrichtung eine Schutzschicht auf das Halbleiterstück aufgebracht wird, so dass die Schutzschicht das Halbleiterstück umschließt, aber in wenigstens einem Bereich eine Öffnung aufweist, durch die die zwischen dem Halbleiterstück und dem Trägersubstrat angeordnete Haftschicht von außen zugänglich ist.

12. Verfahren nach wenigstens einem der vorstehenden Ansprüche, wobei vor dem Ablösen des wenigstens einen Halbleiterstücks von der Haftschicht und dem Trägersubstrat mit der Transfervorrichtung die Haftschicht zwischen dem Halbleiterstück und dem Trägersubstrat entfernt wird.

13. Halbleiter-Zwischenprodukt umfassend ein einkristallines Halbleiterstück mit einer Versetzungsdichte 10⁵ cm⁻² oder weniger, insbesondere von 10⁴ cm⁻² oder weniger, beispielsweise 10² cm⁻² oder weniger, das mittels einer Haftschicht aus Wachs oder Harz auf einem Trägersubstrat fixiert ist.

14. Halbleiter-Die, der eine Halbleiterstruktur mit einem Substrat und einem Halbleiterstück umfasst, wobei das Halbleiterstück eine Versetzungsdichte von 10⁵ cm⁻² oder weniger, insbesondere von 10⁴ cm⁻² oder weniger, beispielsweise 10² cm⁻² oder weniger aufweist.

15. Vorrichtung zum Herstellen einer Halbleiterstruktur umfassend ein Zielsubstrat und wenigstens ein auf dem Zielsubstrat angeordnetes Halbleiterstück, wobei die Vorrichtung ausgebildet ist,
- ein Halbleiterplättchen, das vorzugsweise ein III-V-Halbleiterplättchen ist, mittels einer Haftschicht auf einem Trägersubstrat zu fixieren,
- wenigstens ein Halbleiterstück aus dem Halbleiterplättchen herzustellen, wobei das Halbleiterstück beim Herstellen mittels der Haftschicht auf dem Trägersubstrat fixiert bleibt,
- das wenigstens eine Halbleiterstück von der Haftschicht und dem Trägersubstrat mit einer Transfervorrichtung abzulösen, und
- das Halbleiterstück mit der Transfervorrichtung auf das Zielsubstrat aufzubringen.
